(19)

(11) **EP 2 984 032 B1**

(12) **EUROPÄISCHE PATENTSCHRIFT**

(45) Veröffentlichungstag und Bekanntmachung des Hinweises auf die Patenterteilung:
**24.05.2017 Patentblatt 2017/21**

(21) Anmeldenummer: **14727452.6**

(22) Anmeldetag: **26.05.2014**

(51) Int Cl.:
***B81B 3/00*** (2006.01) ***H02N 1/00*** (2006.01)

(86) Internationale Anmeldenummer:
**PCT/EP2014/060849**

(87) Internationale Veröffentlichungsnummer:
**WO 2014/191361 (04.12.2014 Gazette 2014/49)**

(54) **ELEKTROSTATISCHER AKTUATOR UND VERFAHREN ZUM HERSTELLEN DESSELBEN**
ELECTROSTATIC ACTUATOR AND METHOD FOR THE PRODUCTION THEREOF
ACTIONNEUR ÉLECTROSTATIQUE ET SON PROCÉDÉ DE PRODUCTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.05.2013 DE 102013209804**

(43) Veröffentlichungstag der Anmeldung:
**17.02.2016 Patentblatt 2016/07**

(73) Patentinhaber: **Fraunhofer-Gesellschaft zur Förderung der angewandten Forschung e.V.
80686 München (DE)**

(72) Erfinder:
- **LANGE, Nicolas
07743 Jena (DE)**
- **WIPPERMANN, Frank
98617 Meiningen (DE)**

(74) Vertreter: **Zimmermann, Tankred Klaus et al
Schoppe, Zimmermann, Stöckeler
Zinkler, Schenk & Partner mbB
Patentanwälte
Radlkoferstrasse 2
81373 München (DE)**

(56) Entgegenhaltungen:
**US-A1- 2010 181 866**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 984 032 B1

Printed by Jouve, 75001 PARIS (FR)

## Beschreibung

Die vorliegende Erfindung bezieht sich auf einen elektrostatischen Aktuator mit einer Auslegerelektrode und ein Verfahren zum Herstellen desselben.

Üblicherweise erfolgt der Aufbau eines elektrostatischen Aktuators, hier beispielhaft von einer Unterseite zu einer Oberseite hin beschrieben, in folgender Reihenfolge: eine fixe oder bewegliche erste Elektrode wird an einem ersten Aktuatormaterial angeordnet und von einer Isolationsschicht bedeckt. Auf letzterer wird eine Opferschicht angeordnet, welche wiederum von einer fixen oder beweglichen zweiten Elektrode bedeckt wird. An der zweiten Elektrode wird ein zweites Aktuatormaterial angeordnet. Das Material der Elektroden kann sich sowohl bei erster als auch bei zweiter Elektrode vom Aktuatormaterial unterscheiden, wobei auch das erste Aktuatormaterial vom zweiten Aktuatormaterial verschieden sein kann, insbesondere kann das erste oder zweite Aktuatormaterial ein Substrat sein, an welchem der Aktuator unbeweglich gebildet ist. Nach erfolgter Fügung der Schichten und Elektroden wird die Opferschicht entfernt, woraufhin ein Spalt zwischen den Elektroden im Aufbau verbleibt.

Übliche Fertigungsprozesse elektrostatischer Aktuatoren führen zu einem Luftspalt zwischen den beiden Elektroden eines elektrostatischen Aktuators, unter anderem wegen der eingesetzten Opferschichten. Der aus dem Spalt resultierende Abstand zwischen den Elektroden führt zum einen zu einer deutlichen Erhöhung der zum Betrieb des Aktuators notwendigen elektrischen Spannung, zum anderen zu einer Veränderung des Auslenkungsverhaltens des Aktuators in Abhängigkeit vom aktuell erzielten Auslenkungszustand, bis hin zum "Pull-In"-Effekt.

Die erzeugte Kraft eines elektrostatischen Aktuators nimmt quadratisch mit einem steigenden Abstand der Elektroden zueinander ab. Die Kraft des elektrostatischen Aktuators für den Fall des klassischen Parallelplattenaktuators kann, unter Vernachlässigung der Isolationsschicht, mit der Gleichung

$$F=1/2\ (e_0\ A\ V^2)\ /\ (g-d)^2$$

angegeben werden, wobei F die elektrostatische Kraft, $e_0$ die elektrische Feldkonstante, V die angelegte Spannung, d die spannungsabhängige Auslenkung, A die Kondensatorfläche und g der initiale Abstand der Elektroden zueinander beschreibt. Durch die Geometrie des elektrostatischen Aktuators und der hochgradig nichtlinearen Krafterzeugung, die mit dem Verhältnis $\frac{1}{(g-d)^2}$ quadratisch vom Abstand der Elektroden zueinander abhängig ist, sinkt die Effizienz eines elektrostatischen Aktuators deutlich mit einem steigenden Abstand der Elektroden zueinander. Dieser Abstand ist im Falle eines Parallelplattenaktuators der maximal mögliche Stellweg.

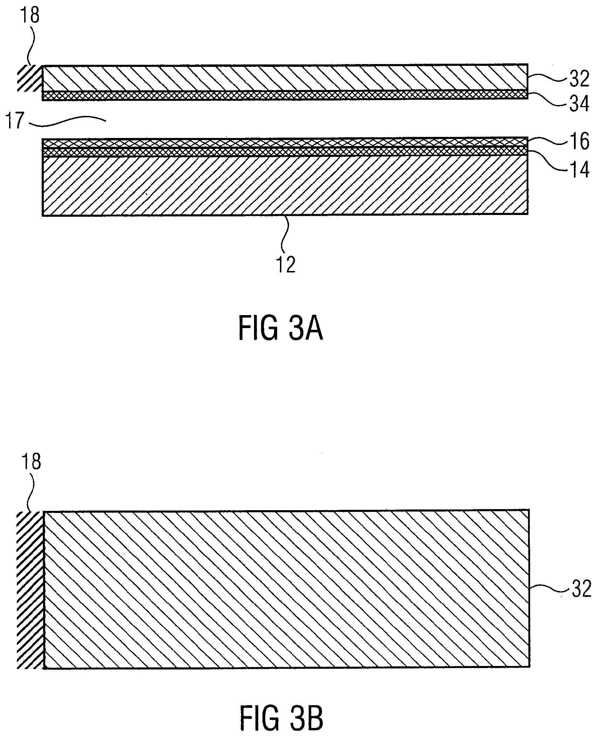

Fig. 3a zeigt eine Seitenansicht eines elektrostatischen Aktuators gemäß dem Stand der Technik, bei dem an einem Substrat 12 eine stationäre Elektrode 14 und an einer dem Substrat 12 abgewandten Seite der stationären Elektrode 14 eine Isolationsschicht 16 angeordnet ist. Der stationären Elektrode 14 gegenüberliegend ist ein an einer festen Einspannung 18 eingespannter Bieger 32 angeordnet. An einer der stationären Elektrode 14 zugewandten Seite des Biegers 32 ist eine bewegliche Elektrode 34 angeordnet, wobei zwischen der beweglichen Elektrode 34 und der Isolationsschicht 16 ein Spalt 17 ausgebildet ist, wobei der Spalt 17 beispielsweise das Resultat des Entfernens einer Opferschicht ist, welche während des oben beschriebenen Herstellungsprozesses des Aktuators angeordnet war.

Ebenjene Anordnung der beiden Elektroden 14 und 34 zueinander mit dem ausgebildeten Spalt 17 zwischen den Elektroden 14 und 34 führt zu den oben beschriebenen Einschränkungen des Aktuators.

Fig. 3b zeigt eine Aufsicht auf den elektrostatischen Aktuator der Fig. 3a. Der an der festen Einspannung 18 angeordnete Bieger 32 ist flächig gleichmäßig ausgeführt.

Sowohl der Spalt 17 zwischen den Elektroden 14 und 34 als auch die nichtlineare Krafterzeugung führen bei Überschreitung einer von der Geometrie und Materialparametern abhängigen Ansteuerspannung zwischen den Elektroden 14 und 34 zu einem Pull-In-Effekt.

Durch fertigungsbedingte Einschränkungen kann der Spalt 17 zwischen den Elektroden 14 und 34 nicht gänzlich geschlossen werden, jedoch wird er mittels Optimierungen des Fertigungsprozesses minimiert. Der durch den verbleibenden Abstand der Elektroden 14 und 34 zueinander verursachte Verlust an elektrostatisch erzeugbarer und nutzbarer Kraft wird dabei in Kauf genommen.

Der Stand der Technik umfasst eine große Anzahl unterschiedlicher Bauformen elektrostatischer Aktuatoren. So zeigen bekannte Realisierungen Bieger oder Platten, die über ein Federelement einseitig eingespannt sind oder beidseitig durch feste Einspannungen oder Federelemente eingespannt sind. Auch bezüglich Geometrie von stationärer Elektrode oder Bieger ist eine große Anzahl unterschiedlicher Realisierungen bekannt, wobei der Spalt zwischen den Elektroden zu oben beschriebene Nachteile in den Realisierungen führt.

Veröffentlichungen beschreiben, wie mittels einer von einem Bieger umfassten sehr weichen Lasche der Spalt zwischen den Elektroden durch elektrostatische Anregung sehr früh, also bereits bei niedriger angelegter elektrischer Spannung, partiell geschlossen werden kann, indem mit der durch die angelegte Spannung bewirkte Anziehungskraft zwischen den Elektroden eine Auslenkung der weichen Lasche hin zu den gegenüberliegenden Elektrode bewirkt wird und die Auslenkung den Spalt an einer Kontaktstelle partiell schließt.

Der Spalt an sich bleibt dennoch bestehen.

Dokument US 2010/0181866 A1 beschreibt ein weiteres Beispiel eines Aktuators gemäß dem Stand der Technik. Die Aufgabe der vorliegenden Erfindung besteht darin, einen elektrostatischen Aktuator und ein Verfahren zur Herstellung desselben zu schaffen, mit welchem die elektrische Spannung zum Betrieb reduziert werden kann.

Diese Aufgabe wird durch einen elektrostatischen Aktuator gemäß Anspruch 1 und ein Verfahren gemäß Anspruch 16 gelöst.

Der vorliegenden Erfindung liegt die Erkenntnis zugrunde, dass die oben beschriebenen Probleme durch ein partielles Schließen des Spalts zwischen den Elektroden mittels einer mechanischen Vorspannung vermieden werden. Durch Anordnen einer Auslegerelektrode kann zudem auch eine Beeinflussung der Kennlinie zwischen angelegter elektrischer Spannung und resultierendem Aktuatorstellweg erzielt werden.

Fertigungsbedingte Spannungen im Material des Biegers können bspw. während Lithografieprozessen realisiert werden und werden genutzt, um den Ausleger gegenüber dem Bieger auszulenken. Durch eine leicht veränderte Geometrie und einem mechanischen Spannungsgradienten können unterschiedlich gekrümmte Bereiche innerhalb eines Aktuators erzeugt werden. Werden diese aufeinander abgestimmt, kann der Spalt zwischen den Elektroden an einer Kontaktstelle partiell geschlossen und/oder zusätzliche Federelemente erzeugt werden. Die zusätzlichen Federelemente können beispielsweise dazu genutzt werden, die Kraft-Auslenkungskurve elektrostatischer Aktuatoren durch mittels der Federelemente angepasste Gegenkräfte zu linearisieren.

Eine weitere und weitaus zuverlässigere sowie technologisch einfachere Möglichkeit zur Anpassung der Auslenkungskurve ist die Anpassung der Elektrodenform, um mittels einer lokal variierenden Elektrodenausbildung eine lokal variierende Stellkraft und mithin eine angepasste Auslenkungskurve zu justieren.

Gemäß einem Ausführungsbeispiel umfasst ein Bieger eine Auslegerelektrode, die in Richtung einer stationären Elektrode ausgelenkt ist, so dass die Auslegerelektrode eine an einer stationären Elektrode angeordnete Isolationsschicht berührt und so den bspw. durch Entfernen einer Opferschicht freigelegten Spalt zwischen den Elektroden partiell an einer Kontaktstelle zwischen Auslegerelektrode und stationären Elektrode schließt. Dadurch werden bei Anlegen einer elektrischen Spannung zwischen den Elektroden hohe Anziehungskräfte erzeugt und bereits bei geringen elektrischen Spannungen eine Auslenkung des Biegers ermöglicht.

Gemäß einem alternativen Ausführungsbeispiel ist der Bieger entlang einer axialen Ausdehnung gekrümmt, so dass ein Abstand zwischen dem Bieger und der stationären Elektrode entlang der Krümmung und von der Einspannung des Biegers ausgehend zunimmt. Diese Anordnung ermöglicht einen vergrößerten Stellweg des Aktuators zwischen einem auslenkbaren Ende und der stationären Elektrode.

Gemäß einem weiteren Ausführungsbeispiel sind zwei elektrostatische Aktuatoren derart angeordnet, dass die auslenkbaren Enden der Bieger gegenüberliegend sind und eine Federstruktur zwischen den auslenkbaren Enden angeordnet ist, die eine rückstellende Kraft bezüglich einer den Aktuator auslenkenden elektrostatischen Kraft erzeugt. Damit kann das Spannungs-Auslenkungsverhalten zusätzlich beeinflusst werden.

Gemäß einem weiteren Ausführungsbeispiel ist an dem frei auslenkbaren Ende des Biegers ein Balkenelement angeordnet, welches mit einer Hebelwirkung den Stellweg des elektrostatischen Aktuators vergrößert.

Weitere vorteilhafte Ausführungsformen sind der Gegenstand der abhängigen Patentansprüche.

Ausführungsbeispiele der vorliegenden Erfindung werden nachfolgend Bezug nehmend auf die beiliegenden Zeichnungen erläutert. Es zeigen:

Fig. 1a eine Seitenansicht eines elektrostatischen Aktuators, dessen Bieger eine Auslegerelektrode umfasst, die in Richtung der stationären Elektrode ausgelenkt ist und einen Spalt zwischen den Elektroden mit Ausnahme einer Isolationsschicht schließt;

Fig. 1b eine Aufsicht des elektrostatischen Aktuators aus Fig. 1a;

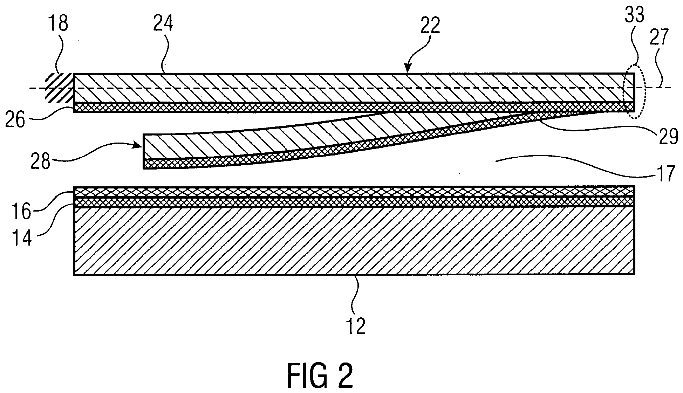

Fig. 2 eine Seitenansicht eines elektrostatischen Aktuators analog Fig. 1a, bei dem die Auslegerelektrode in Richtung der stationären Elektrode ausgelenkt ist und den Spalt zwischen den Elektroden partiell reduziert;

Fig. 3a eine Seitenansicht eines elektrostatischen Aktuators gemäß dem Stand der Technik ohne eine Auslegerelektrode;

Fig. 3b eine Aufsicht des elektrostatischen Aktuators aus Fig. 3a;

Fig. 4a einen elektrostatischen Aktuator analog Fig. 1a, wobei der Bieger eine mechanische Vorspannung umfasst, so dass der Bieger eine Krümmung aufweist;

Fig. 4b eine Aufsicht des elektrostatischen Aktuators aus Fig. 4a;

Fig. 5a eine Aufsicht auf einen elektrostatischen Aktuator mit einem rechteckig geformten Ausleger;

Fig. 5b eine Aufsicht auf einen elektrostatischen Aktuator mit einem dreieckig geformten Ausleger;

Fig. 5c eine Aufsicht auf einen elektrostatischen Aktuator mit einem trapezförmig geformten Ausleger;

Fig. 5d eine Aufsicht auf einen elektrostatischen Aktuator mit einem rechteckig geformten Ausleger, dessen auslenkbares Ende entlang des axialen Verlaufs des Biegers verläuft;

Fig. 6a eine Aufsicht auf einen elektrostatischen Aktuator analog Fig. 5a mit einem verkleinerten Ausleger, welcher benachbart zur festen Einspannung angeordnet ist;

Fig. 6b eine Aufsicht auf einen elektrostatischen Aktuator analog Fig. 6a mit einem verkleinerten Ausleger, welcher benachbart zum auslenkbaren Ende des Biegers angeordnet ist;

Fig. 6c eine Aufsicht auf einen elektrostatischen Aktuator mit je einem Ausleger analog Fig. 6a und Fig. 6b;

Fig. 7a eine Seitenansicht zweier gegenüberliegend angeordneter elektrostatischer Aktuatoren, deren auslenkbares Ende über ein Federelement verbunden ist;

Fig. 7b eine Aufsicht des elektrostatischen Aktuators aus Fig. 7a;

Fig. 8 eine Aufsicht auf einen rund ausgeformten elektrostatischen Aktuator mit vier Auslegern;

Fig. 9a eine Seitenansicht eines elektrostatischen Aktuators mit Vorkrümmung und Auslenkerelektrode gemäß Fig. 4a

Fig. 9b Darstellungen verschiedener, beispielhafter Elektrodengeometrien;

Fig. 9c Graphen mit beispielhafter Aktuatorauslenkungen der verschiedenen Elektrodengeometrien aus Fig. 9b;

Fig. 10a eine Aufsicht auf einen elektrostatischen Aktuator in einem unausgelenkten Zustand, an dessen auslenkbarem Ende ein Balkenelement angeordnet ist;

Fig. 10b eine Seitenansicht des elektrostatischen Aktuators aus Fig. 10a;

Fig. 10c eine Seitenansicht des elektrostatischen Aktuators analog Fig. 10b in einem ausgelenkten Zustand;

Fig. 10d eine Aufsicht auf den elektrostatischen Aktuator der Fig. 10a-c im ausgelenkten Zustand analog Fig. 10c;

Fig. 11a eine Aufsicht auf einen elektrostatischen Aktuator analog Fig. 10a, bei dem der Bieger gegenüber dem Balkenelement eine geringere axiale Ausdehnung umfasst;

Fig. 11b eine Seitenansicht des elektrostatischen Aktuators der Fig. 11a analog Fig. 10b;

Fig. 11c eine Seitenansicht des elektrostatischen Aktuators analog Fig. 11b des elektrostatischen Aktuators in einem ausgelenkten Zustand;

Fig. 11d eine Aufsicht auf den elektrostatischen Aktuator analog Fig. 11a in einem ausgelenkten Zustand analog Fig. 11c;

Fig. 12a eine Aufsicht auf einen elektrostatischen Aktuator analog Fig. 11a, bei der in einem Bereich des Balkenelements eine Balkenelektrode angeordnet ist;

Fig. 12b eine Seitenansicht des Aktuators gemäß Fig. 12a analog Fig. 11b;

Fig. 12c eine Seitenansicht des Aktuators analog Fig. 12b, bei dem das zusätzlich angeordnete Balkenelement ausgelenkt ist;

Fig. 12d eine Aufsicht des elektrostatischen Aktuators analog Fig. 12a im ausgelenkten Zustand analog Fig. 12c.

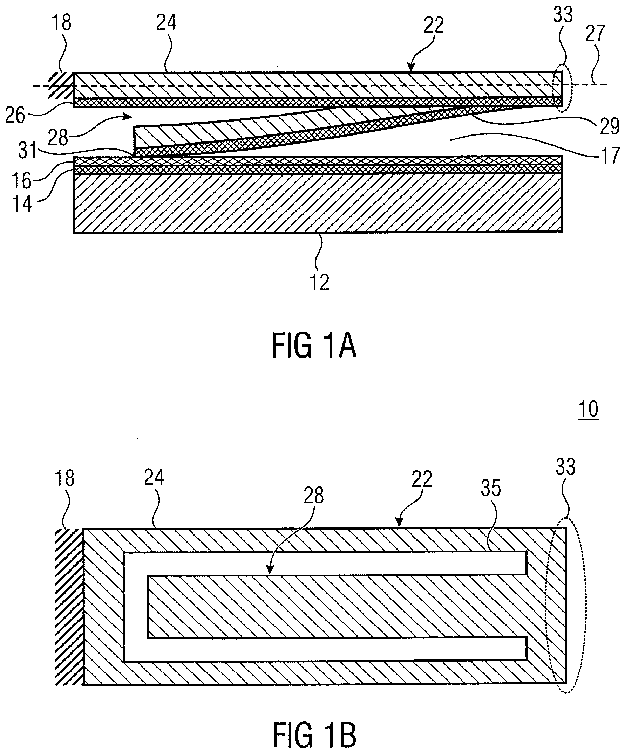

Fig. 1a zeigt eine Seitenansicht einer Vorrichtung 10 mit einem elektrostatischen Aktuator. An einem Substrat 12 ist eine stationäre Elektrode 14 angeordnet, welche flächig von einer Isolationsschicht 16 bedeckt ist. Der stationären Elektrode 14 ist beabstandet durch einen Spalt 17 ein an einer festen Einspannung 18 angeordneter Bieger 22 gegenüberliegend angeordnet, wobei der Bieger ein verformbares Aktuatormaterial 24 und eine daran angeordnete Biegerelektrode 26 umfasst. Eine neutrale Faser 27 des Biegers 22 verläuft parallel zur stationären Elektrode 14. Ein Bereich des Biegers 22 definiert einen Ausleger 28 und ist in Richtung der stationären Elektrode 14 ausgelenkt, wobei an einer der stationären Elektrode 14 zugewandten Oberfläche des Auslegers 28 eine Auslegerelektrode 29 angeordnet ist, welche elektrisch gegenüber der Biegerelektrode 26 getrennt ist, so dass zwischen Biegerelektrode 26 und Auslegerelektrode 29 ein voneinander verschiedenes elektrisches Potenzial anlegbar ist. Der Ausleger 28 ist ohne dass ein elektrischen Feld angelegt wurde im Ruhezustand derart vorausgelenkt, dass die Auslegerelektrode 29 die Isolationsschicht 16 an einer Kontaktstelle 31 berührt und an dieser Kontaktstelle 31 den Spalt 17 zwischen der Auslegerelektrode 29 und der stationären Elektrode 14 partiell schließt. Über einen axialen Verlauf des Biegers von der festen Einspannung 18 hin zu einem, einer eingespannten Seite des Biegers gegenüberliegend angeordneten, auslenkbaren Ende 33 weist der Bieger 22, mit Ausnahme der Auslegerelektrode 29, im Ruhestand und mithin ohne dass ein elektrisches Feld angelegt wurde einen annähernd konstanten Abstand zwischen dem Bieger und der Isolationsschicht 16 und mithin der stationären Elektrode 14 auf, wobei in diesen Abstand der Spalt 17 ausgebildet ist.

Fig. 1b zeigt eine Aufsicht auf die Vorrichtung der Fig. 1a. Der Bieger 22 ist an seinem eingespannten Ende über eine laterale Ausdehnung einer gesamten Breite des Biegers 22 fest eingespannt. Der Bieger 22 umfasst eine Aussparung 35, die den Ausleger 28 derart ausbildet, dass ein Übergang vom Ausleger 28 zum Bieger 22 benachbart zum auslenkbaren Ende des Biegers 22 angeordnet ist, so dass der Ausleger 28 an einer der Einspannung 18 zugewandten Seite aus einer Ebene, in der der Bieger angeordnet ist, in Richtung der stationären Elektrode ausgelenkt ist, wie in Fig. 1a gezeigt. Die Aussparung 35 kann während eines Herstellungsverfahrens bspw. durch nicht Ausbilden des Biegers an den Orten der Aussparung 35 oder durch ein nachträgliches Entfernen von Material realisiert sein.

Neben der partiellen Schließung des Spalts 17 zwischen der Auslegerelektrode 29 und der stationären Elektrode 14 an der Kontaktstelle 31, welche die für eine Auslenkung des auslenkbaren Endes des Biegers benötigte Spannung reduziert, bewirkt die Nähe zwischen der Auslegerelektrode 29 und der Elektrode 14 eine erhöhte Krafterzeugung zwischen dem Bieger 22 und der stationären Elektrode 14, was einen nutzbaren Stellweg des Biegers 22 und mithin des Aktuators vergrößert und die notwendige Steuerspannung verringert. Durch die Geometrie des Auslegers kann weiterhing eine Anpassung des Auslenkungsverhaltens erfolgen und der maximale Stellweg bis zum Pull-In-Effekt, welcher dazu führt, dass der Bieger 22 schlagartig in Richtung der stationären Elektrode 14 ausgelenkt wird, beeinflusst werden. Durch eine Anpassung der Fertigungsparameter und mittels einer geringfügig anderen Geometrie der Elektroden 14, 26 und 29 in Verbindung mit einer mechanischen Vorspannung, welche die Auslegerelektrode 29 hin zur stationären Elektrode bewegt, wird der Spalt zwischen den beiden Elektroden 14 und 29 derart geschlossen, dass lediglich die Isolationsschicht zur Kurzschlussvermeidung zwischen den Elektroden 14 und 29 angeordnet ist. Damit ist eine Auslenkung des Aktuators auch bei geringen elektrischen Spannungen möglich.

Die gegenwärtigen Fertigungsprozesse werden zur Umsetzung des elektrostatischen Aktuators mit einer Auslegerelektrode nur geringfügig verändert. Der Ausleger wird in eine Richtung senkrecht zu einer Fertigungsebene, welche parallel zur Ebene der stationären Elektrode 14 verläuft, ausgelenkt, womit der Spalt 17 zwischen den Elektroden 14 und 29 an der Kontaktstelle 31 partiell geschlossen und womit die Performance wesentlich verbessert wird.

Eine geeignete Anpassung der Geometrie, Position oder des grundsätzlichen Design des Auslegers 28 oder der Auslegerelektrode 29 ermöglicht zudem, ein Verhältnis von an den Elektroden 14, 26 oder 29 angelegter Spannung und Auslenkung des Aktuators einzustellen, insbesondere dieses Verhältnis zu linearisieren. Bei polymerbasierten elektrostatischen Aktuatoren kann dies durch eine geringe Anpassung der Fertigungsparameter geschehen. Dabei wird unter anderem ausgenutzt, dass der sich gegenüber der stationären Elektrode 14 nähernde Ausleger 28 eine erhöhte elektrostatische Kraft erzeugt, wobei diese Kraft durch die Geometrie des Auslegers 28 und/oder der Auslegerelektrode 29 sowie der stationären Elektrode 34 definiert wird, um die notwendige Versorgungsspannung zu reduzieren, bzw. den Pull-In-Effekt zu verhindern, wobei die Geometrien auch ausgelegt werden können, um ein linearisiertes Verhältnis zwischen an den Aktuatoren angelegter Spannung und resultierendem Aktuatorstellweg einzustellen.. Dabei können sämtliche Elektroden 26 und 29 auch getrennt voneinander angesteuert werden oder sind alternativ miteinander verschaltet.

Der Ausleger 28 umfasst die Auslegerelektrode 29, die sowohl mit der von dem Bieger 22 umfassten Biegerelektrode 26 verschaltet, aber auch getrennt angesteuert werden kann. Die Auslenkungskurve des elektrostatischen Aktuators kann in Abhängigkeit von Position und Designs des Auslegers bzw. der Ausleger in Abhängigkeit von den Anforderungen an den Aktuator angepasst werden, wie in späteren Ausführungsbeispielen dargelegt wird. Die durch die Vorauslenkung erzeugte Gegenkraft gegenüber der stationären Elektrode kann als mechanisches Widerstands- oder Federelement oder, mit elektrischer Anregung, als zusätzliches Anzugselement genutzt werden.

In alternativen Ausführungsbeispielen sind die Biegerelektrode und die Auslegerelektrode einstückig miteinander gebildet, so dass ein Anlegen einer elektrischen Spannung an der Bieger- oder der Auslegerelektrode auch zu einem Anlegen der elektrischen Spannung an der jeweils anderen Elektrode führt.

Das Aktuatormaterial oder das Substrat ist gemäß alternativen Ausführungsbeispielen einstückig mit der Biegerelektrode und/oder der Auslegerelektrode gebildet, so dass bspw. ein flächiger Abschnitt eines leitfähigen Materials an der festen Einspannung angeordnet ist und den Ausleger umfasst.

Ausführungsbeispiele umfassen mehrere solcher Aufbauten, freistehende und/oder eingespannte Biegebalken, Stege, Federelemente und Ausleger umfassend. Ferner zeigen Ausführungsbeispiele eine Anordnung mehrerer solcher Aufbauten in einer Vorrichtung, wobei deren Anordnung prinzipiell nebeneinander, parallel, radial oder als kleinere Elemente in größeren Systemen angeordnet sein können.

Fig. 3 zeigt eine Seitenansicht eines elektrostatischen Aktuators analog Fig. 1a, bei dem der Ausleger 28 in Richtung der stationären Elektrode 14 ausgelenkt ist, so dass der Spalt 17 über die axiale Ausdehnung des Biegers partiell verkleinert ist und der Ausleger 28 zu der Isolationsschicht 16 in einem elektrisch spannungsfreien Zustand beabstandet angeordnet ist.

Je nach Anordnung bzw. Auslenkung des Auslegers gegenüber der stationären Elektrode kann der Spalt zwischen Ausleger und stationärer Elektrode partiell verkleinert oder partiell geschlossen sein. Eine zunehmende Reduktion des Spaltes führt zu einer zunehmenden Reduktion der für eine Auslenkung des elektrostatischen Aktuators benötigten elektrischen Spannung, so dass ein Auslenkungsverhalten des elektrostatischen Aktuators über die partielle Verkleinerung bzw. partielle Schließung des Spaltes beeinflusst werden kann.

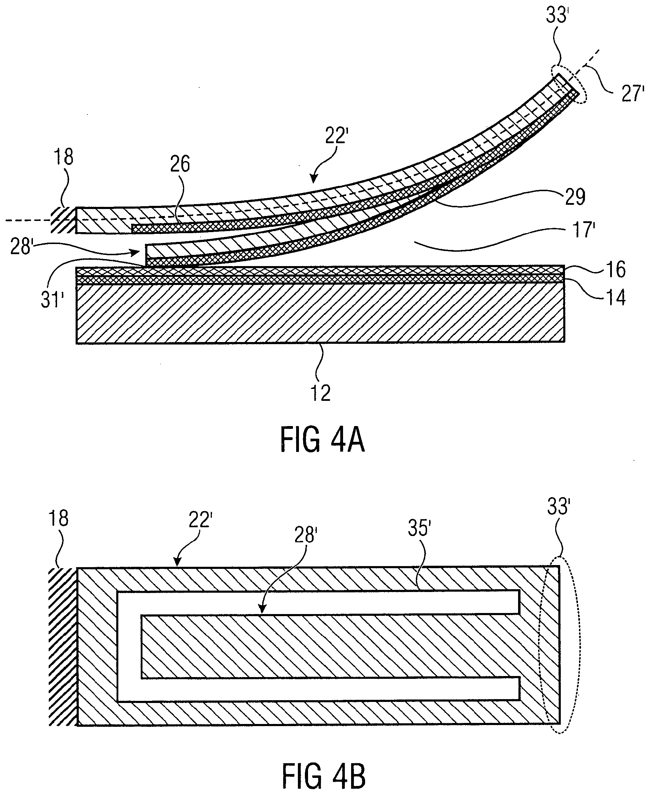

Fig. 4a zeigt eine Seitenansicht eines elektrostatischen Aktuators analog Fig. 1a, wobei ein Bieger 22' im Gegensatz zum Bieger 22 aus Fig. 1a mechanisch vorgespannt ist, so dass ein auslenkbares Ende 33', welches der festen Einspannung 18 gegenüberliegend angeordnet ist, von der stationären Elektrode 14 wegweisend ausgelenkt ist. Damit weist die Ebene, in welcher eine neutrale Faser 27' des Biegers 22' angeordnet ist, eine Krümmung auf. Ein vom Bieger 22' umfasster und durch eine Aussparung 35' definierter Ausleger 28' weist analog dem Ausleger 28 aus Fig. 1 einen Spannungsgradienten und mithin eine mechanische Vorspannung gegenüber dem Bieger 22' derart auf, dass ein Spalt 17' zwischen der Auslegerelektrode 29 und der stationärer Elektrode 14 im Ruhezustand und mithin ohne dass ein elektrisches Feld angelegt ist partiell geschlossen ist, so dass an einer Kontaktstelle 31' lediglich die Isolationsschicht 16 zwischen den Elektroden 14 und 29 angeordnet ist.

Die mechanische Vorspannung des Biegers 22' führt zu einem gegenüber Fig. 1 vergrößerten Abstand zwischen dem auslenkbaren Ende 33' und der stationären Elektrode 14 und mithin zu einem vergrößerten nutzbaren Stellweg des Aktuators. Gleichzeitig umfasst der Bieger 22' zusätzlich eine Rückstellkraft durch den Ausleger 28'.

Fig. 4b zeigt eine Aufsicht auf den elektrostatischen Aktuator aus Fig. 4a. Die Aufsicht ist identisch zur Fig. 1b, da die mechanischen Vorspannungen des an der festen Einspannung 18 angeordneten Biegers 22' und des Auslegers 28' zu einer Krümmung des Biegers 22' und des Auslegers 28' in Richtung des Betrachters führen, so dass die Aufsicht unverändert bleibt.

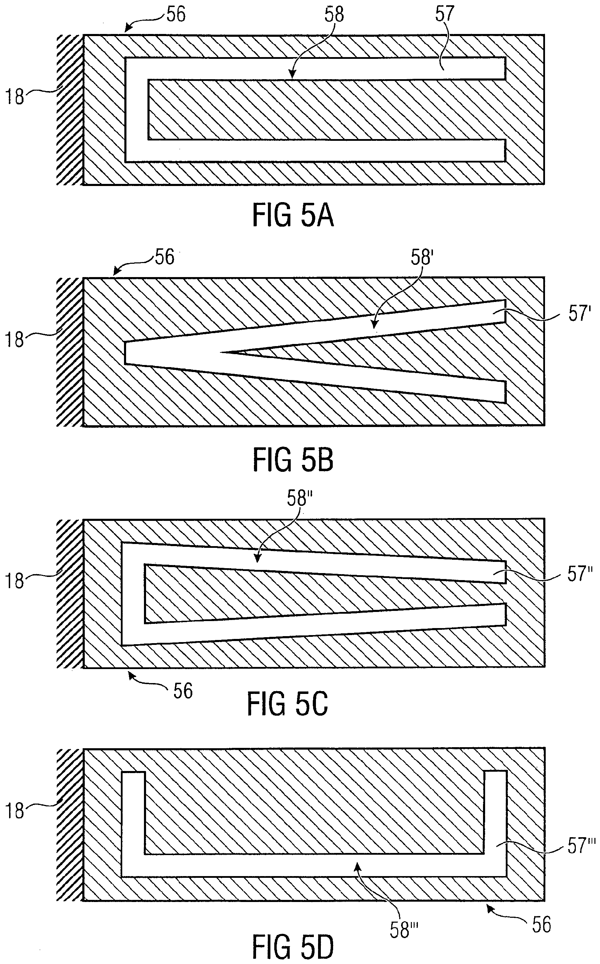

Die Figuren 5a-d zeigen jeweils unterschiedliche mögliche Ausgestaltungsformen eines durch eine Aussparung definierten und von einem Bieger 56 umfassten Auslegers.

Fig. 5a zeigt einen Ausleger 58, welcher analog den vorangegangenen Ausführungsbeispielen rechteckig durch eine Aussparung 57 ausgeformt ist und ein auslenkbares Ende umfasst, welches benachbart zur festen Einspannung 18 angeordnet ist.

Fig. 5b zeigt einen alternativen Ausleger 58', welcher durch die Aussparung 57' dreieckig ausgeformt ist, wobei sich der Ausleger 58' von einem auslenkbaren Ende zu einem gegenüberliegend und benachbart zu der festen Einspannung 18 angeordneten festen Ende hin verjüngt. Mit einer derartigen Ausgestaltungsform wird erreicht, dass sowohl die mechanische Kraft zwischen Ausleger 58' und stationärer Elektrode entlang des Verlaufs des Auslegers 58' justiert wird als auch, dass die durch ein Anlegen einer elektrischen Spannung zwischen Auslegerelektrode und stationärer Elektrode induzierte Kraft zwischen Ausleger 58' und/oder Bieger 56 gegenüber der stationären Elektrode durch die Geometrie der Aussparung 57' und mithin des Auslegers 58' definiert wird. Ein sich verjüngender Ausleger 58' weist am verjüngten Ende eine geringere Steifigkeit und mithin eine geringere Rückstellkraft auf. Gleichzeitig verjüngt sich die Fläche in welcher sich Auslegerelektrode und stationäre Elektrode gegenüberliegen, sodass die anziehende Kraft zwischen den Elektroden an verjüngten Stellen geringer ist.

Fig. 5c zeigt den Bieger 56 mit einem Ausleger 58", welcher trapezförmig ausgestaltet ist, wobei sich der Ausleger 58" vom an der festen Einspannung 18 angeordneten unbeweglichen Ende ausgehend hin zu einem gegenüberliegend angeordneten auslenkbaren Ende hin verjüngt.

In Fig. 5d weist ein Ausleger 58'" eine ebenfalls rechteckige Form auf, ist jedoch gegenüber den Figuren 5a-c derart orientiert, dass ein auslenkbares Ende des Auslegers 58'" entlang einer Richtung vom fest eingespannten und benachbart zur festen Einspannung 18 angeordneten Ende hin zum gegenüberliegend angeordneten auslenkbaren Ende verläuft, so dass der Ausleger gegenüber den Figuren 5a-c um 90° gedreht ist und eine Kontaktstelle zwischen dem Ausleger 58"" und der stationären Elektrode bzw. der Isolationsschicht alternativ zu vorangegangenen Ausführungsformen entlang des axialen Verlaufs der stationären Elektrode verläuft.

Prinzipiell ist eine beliebige Ausgestaltungsform eines Auslegers innerhalb des Biegers realisierbar. Die Orientierung und die Geometrie eines Auslegers ist dabei an die Anforderungen der jeweiligen späteren Anwendung angepasst. Ein Ausleger ohne elektrostatische Funktion, beispielsweise aufgrund einer Nichtkontaktierung bzw. Nichtanlegen einer elektrischen Spannung an der Elektrode, erlaubt eine Nutzung des Auslegers als Federelement, um die Auslenkungskurve des elektrostatischen Aktuators durch die Geometrie und Materialwahl definierten Anforderungen anzupassen, indem der Ausleger in seiner Position, Länge, Geometrie und/oder mechanischer Vorspannung entsprechend den definierten Anforderungen ausgelegt ist.

Eine in den Figuren 5a-d beschriebene Anpassung der Elektrodengeometrie führt zu einer Kapazitätsänderung während einer Biegeraktuierung. Eine Auslenkung des Aktuators führt zu einem abnehmenden Abstand zwischen Ausleger und stationärer Elektrode, wobei durch den variablen Abstand eine Änderung der Kapazität ausgelöst wird, wodurch der Aktuator zusätzlich nichtlineares Auslenkungsverhalten zeigt. Dieses nichtlineare Auslenkungsverhalten kann durch eine geometrische Anpassung der Ausleger- und/oder der stationären Elektrode justiert werden, um beispielsweise einen linearen Verlauf der Kapazitätsänderung oder einen konstanten Verlauf der Kapazität einzustellen. Über eine Anpassung der Elektrodenform kann das Auslenkungsverhalten des Aktuators beeinflusst und zudem auch der Pull-In-Effekt vollständig verhindert werden. Die Elektrodenform wird somit der Kapazitätsänderung des Aktuators bei zunehmender Auslenkung angepasst.

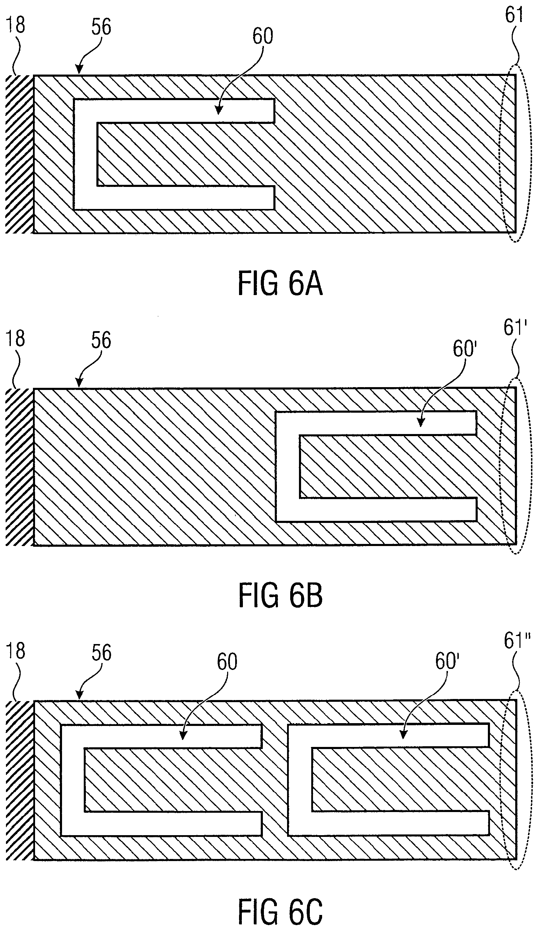

Fig. 6a zeigt eine Aufsicht auf den Bieger 56 der Fig. 5a mit einem auslenkbaren Ende 61, und einem alternativen Ausleger 60, welcher gegenüber dem Ausleger 58 der Fig. 5a verkleinert ist. Der Ausleger 60 ist benachbart zum fest eingespannten Ende des Biegers 56 angeordnet.

Fig. 6b zeigt eine Aufsicht auf den Bieger 56 mit einem Ausleger 60' analog dem Ausleger 60 aus Fig. 6a, wobei Ausleger 60' benachbart zu einem auslenkbaren Ende 61' des Biegers 56 angeordnet ist.

Fig. 6c zeigt eine Aufsicht auf den Bieger 56, welcher einen Ausleger 60 analog Fig. 6a und einen Ausleger 60' analog 5b umfasst, so dass zwei Ausleger 60 und 60' von dem Bieger 56 umfasst werden, deren daran angeordnete Elektroden gemäß vorherigen Ausführungsbeispielen getrennt von einander ansteuerbar sind. Die beiden Ausleger 60 und 60' können alternativ oder zusätzlich eine von einander verschiedene mechanische Vorspannung umfassen, um unterschiedliche Kräfte und Abstände zwischen Bieger und stationärer Elektrode zu realisieren.

Alternative Ausführungsbeispiele umfassen Ausleger mit beliebig vielen, gleich oder unterschiedlich ausgeformten Auslegern.

Prinzipiell können mehrere, von einem Bieger umfasste Elektroden elektrisch von einander getrennt oder getrennt von einander ansteuerbar oder elektrisch mit einander verschaltet und mithin gemeinsam ansteuerbar ausgebildet sein.

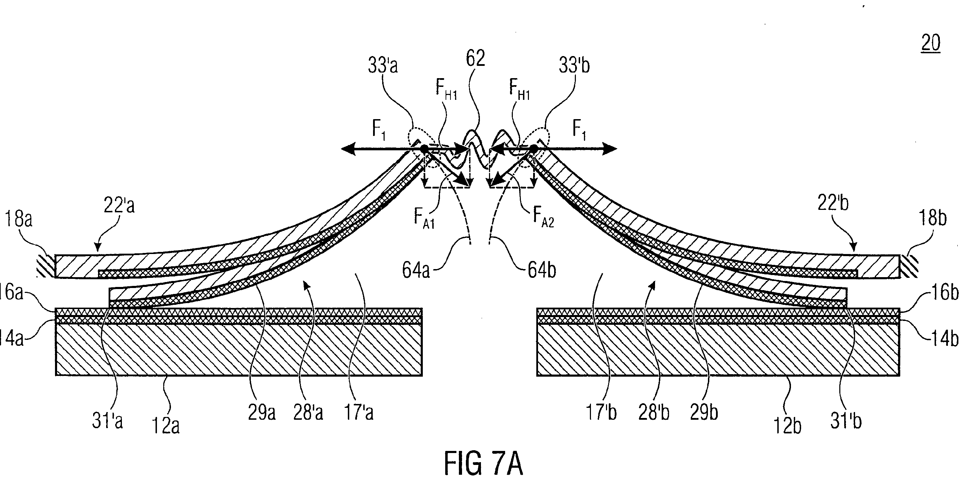

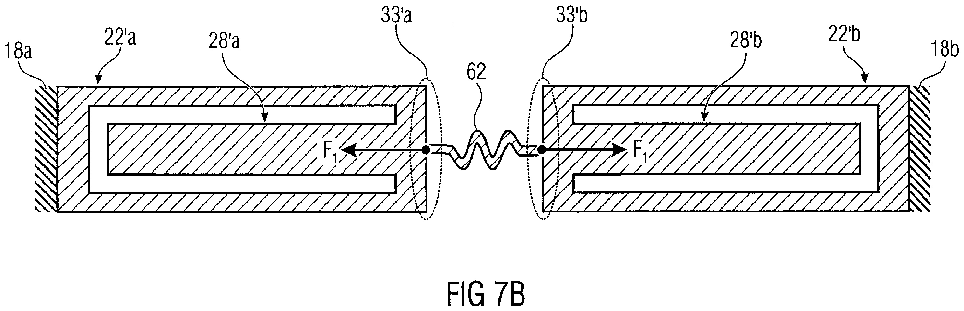

Fig. 7 zeigt eine Vorrichtung 20, welche zwei elektrostatische Aktuatoren gemäß Fig. 4 umfasst, die über ein Federelement miteinander verbunden sind.

Fig. 7a zeigt eine Seitenansicht der Vorrichtung 20, wobei die beiden elektrostatischen Aktuatoren derart zueinander angeordnet sind, dass die auslenkbaren Enden 33'a und 33'b der Bieger 22'a und 22'b gegenüberliegend sind. Ein Federelement 62 ist derart angeordnet, dass es die beiden auslenkbaren Enden 33'a und 33'b der Bieger 22'a und 22'b miteinander verbindet. Werden einer oder beide elektrostatischen Aktuatoren angesteuert, so bewegt sich das auslenkbare Ende 33'a des Biegers 22'a entlang eines Weges 64a und das auslenkbare Ende 33'b des Biegers 22'b entlang eines Weges 64b, wobei sich ein Abstand zwischen den auslenkbaren Enden 33'a und 33'b der Bieger 22'a und 22'b bei gleichzeitiger Ansteuerung verringert. Das Federelement 62 wird bei zunehmend reduziertem Abstand zwischen den auslenkbaren Enden 33'a und 33'b der Bieger 22'a und 22'b durch einen Anteil $F_{H1}$ bzw. $F_{H2}$ einer Aktuatorkraft $F_{A1}$ und $F_{A2}$ zunehmend gestaucht und bewirkt eine Kraft $F_1$, die der Auslenkung der Bieger 22'a und 22'b entgegenwirkt. Mit zunehmender Auslenkung der Bieger 22'a und 22'b wächst die Kraft $F_1$ an, so dass eine maximale Auslenkung der Bieger 22'a und 22'b existiert, die von der durch das Federelement 62 induzierten Gegenkraft $F_1$ begrenzt wird, wenn der Anteil $F_{H1}$ bzw. $F_{H2}$ gleich der entgegengesetzt wirkenden Kraft $F_1$ ist und ein Kräftegleichgewicht eintritt.

Durch die Anordnung des Federelements 62 und die Limitierung des Stellweges der Aktuatoren wird das Auslenkungsverhalten des Aktuators abhängig von einer Federkonstante oder einer Federgeometrie beeinflusst. Der Pull-In-Effekt kann durch eine nichtlineare bzw. durch die Federgeometrie definierten Auslegung der Federkonstante in Abhängigkeit von aus der späteren Anwendung des Aktuators resultierenden Anforderungen vollständig verhindert, oder so justiert werden, dass der Pull-In-Effekt einen zuvor definierten Betriebspunkt anzeigt.

Fig. 7b zeigt eine Aufsicht auf Vorrichtung 20 aus Fig. 7a. Das Federelement 62 ist in etwa mittig entlang einer lateralen Ausdehnung der auslenkbaren Enden 33'a und 33'b der Bieger 22'a und 22'b angeordnet, um bei einer Stauchung des Federelements 62, resultierend in der Kraft $F_1$, eine Verkippung des Biegers 22'a gegenüber dem Bieger 22'b zu verringern. In alternativen Ausführungsbeispielen ist das Federelement 62 derart angeordnet, dass eine vordefinierte Verkippung eines Biegers gegenüber einem anderen Bieger erzielt wird. In weiteren Ausführungsbeispielen ist das Federelement flächig entlang dem jeweiligen auslenkbaren Ende eines Biegers angeordnet, so dass die rückstellende Kraft $F_1$ ebenfalls flächig eingeleitet wird.

In alternativen Ausführungsbeispielen ist ein Federelement derart zwischen Biegern angeordnet, dass ein linearisiertes Verhältnis zwischen an den Elektroden angelegter Spannung und resultierendem Aktuatorstellweg eingestellt ist. Alternativ oder zusätzlich kann ein Eintreten des Pull-In-Effekts auch zugelassen werden.

In weiteren Ausführungsbeispielen ist an dem Federelement ein Funktionselement angeordnet, bspw. eine optische Struktur, welche mit den auslenkbaren Enden der Aktuatoren und dem Federelement durch Auslenken zumindest eines Aktuators im Raum bewegt wird.

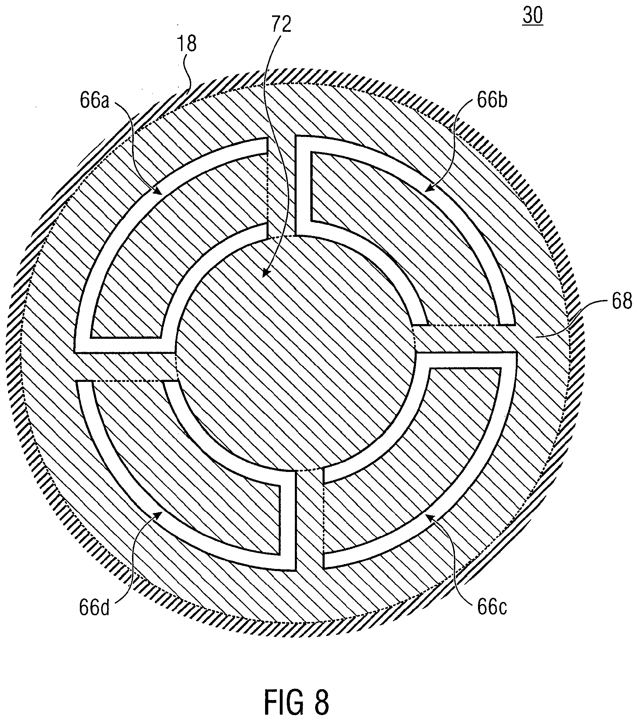

Fig. 8 zeigt eine Aufsicht auf eine Vorrichtung 30 mit einem rund ausgebildeten elektrostatischen Aktuator und vier symmetrisch angeordneten und je ein Viertel eines Kreisbogens beschreibenden Auslegern 66a-d. Die Ausleger 66a-d umfassen eine mechanische Vorspannung analog Fig. 1, wohingegen ein äußerer Bereich 68 sowie ein innerer Bereich 72 des Aktuators ohne eine mechanische Vorspannung ausgebildet sind, so dass der äußere Bereich 68 und der innere Bereich 72 analog Fig. 1 eben ausgebildet ist. Die Ausleger 66a-d sind aus der Ebene des Aktuators ausgelenkt und schließen an vier Kontaktstellen jeweils partiell einen Spalt zwischen einer an den Auslegern 66a-d angeordneten Elektrode und einer gegenüberliegend angeordneten statischen Elektrode, analog Fig. 1a. Durch eine getrennte Ansteuerung der Elektroden der Ausleger 66a-d ist eine Verkippung des inneren Bereichs 72 erzielbar, wodurch ein an dem inneren Bereich 72 angeordnetes Objekt im Raum verkippt oder bei gleicher Ansteuerung der Ausleger 66a-d im Raum bewegt werden kann.

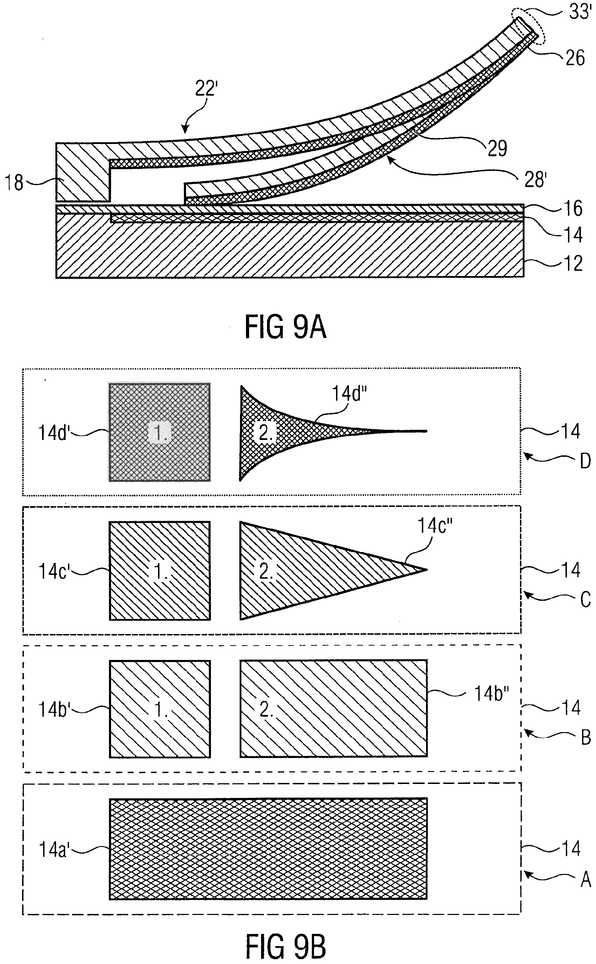

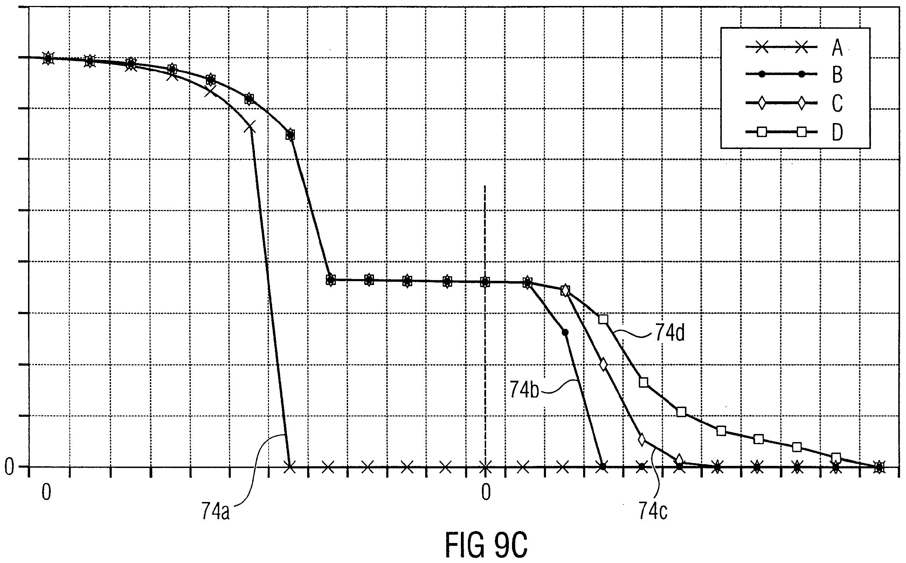

Fig. 9a zeigt eine Seitenansicht eines elektrostatischen Aktuators analog Fig. 4a für welchen in Fig. 9c Auslenkungen für unterschiedliche Varianten A-D der stationären Elektrode 14 dargestellt werden. Fig. 9b zeigt Aufsichten auf vier Ausgestaltungsformen der stationären Elektrode 14 mit jeweils einem oder zwei Segmenten, wobei jedes Segment unabhängig von einander mit einer elektrischen Spannung beaufschlagt werden kann.

Das Verhalten der unterschiedlichen Ausgestaltungsformen der stationären Elektrode 14 bezüglich der Auslenkkurve des Aktuators wird in nachfolgender Fig. 9c dargestellt. In Variante A ist die stationäre Elektrode 14 durch ein Segment 14'a über die gesamte Ausdehnung einstückig ausgebildet. Die stationäre Elektrode 14 umfasst in Variante B die beiden Segmente 14b' und 14b", wobei jedes der beiden Segmente 14b' und 14b" unabhängig voneinander mit einer elektrischen Spannung beaufschlagt werden kann. Beide Segmente 14b' und 14b" sind rechteckig ausgeformt, wobei beide Segmente 14b' und 14b" eine gleiche laterale Ausdehnung umfassen und das Segment 14b" eine größere axiale Ausdehnung umfasst als das Segment 14b'. In Variante C umfasst die stationäre Elektrode 14 zwei Segmente 14c' und 14c", wobei das Segment 14c" gegenüber dem Segment 14b" dreieckig ausgebildet ist und eine Verjüngung zu einem dem Segment 14c' abgewandten Ende hin aufweist. In Variante D umfasst ein Segment 14d" eine Verjüngung analog dem Segment 14c", wobei die Verjüngung einen nichtlinearen, konkaven Verlauf aufweist. Die Segmente 14b', 14c' und 14d' weisen eine zueinander identische Form auf. Die Segmente 14b', 14c' und 14d' sind benachbart zur festen Einspannung 18 angeordnet, wobei die Segmente 14b", 14c" und 14d" benachbart zu den jeweiligen Segmenten 14b', 14c' und 14d' in einer, der festen Einspannung 18 abgewandten Richtung und dem Bieger 22' gegenüberliegend angeordnet sind und wobei ein verjüngtes Ende des Segmentes 14c" bzw. 14d" dem auslenkbaren Ende 33' des Biegers 22' gegenüberliegend angeordnet ist.

Fig. 9c zeigt für einen Aufbau mit den in Fig. 9b beschriebenen Varianten A-D der stationären Elektrode 14 qualitativ die jeweils erzielbaren Auslenkungen eines die Elektroden umfassenden elektrostatischen Aktuators in Abhängigkeit von den angelegten Ansteuerspannungen. Die Ordinate des Graphen zeigen dabei den Abstand des auslenkbaren Endes des Biegers 22' aus Fig. 9a zur Isolationsschicht 16. Über die Abszisse sind die Ansteuerspannungen aufgetragen, wobei in einem ersten Abschnitt der Abszisse von der Ordinate ausgehend eine ansteigende Ansteuerspannung der Segmente 14a', 14b', 14c' und 14d' aufgetragen ist und in einem zweiten Abschnitt der Abszisse, an der gestrichelten Linie durch den Abszissenwert 0 dargestellt, eine Zuschaltung der zweiten Segmente 14b", 14c" und 14d".

Der Verlauf eines ersten Graphen 74a zeigt die Auslenkung des auslenkbaren Endes 33'für die Variante A der stationären Elektrode 14. Mit von 0 aus inkrementell ansteigender Ansteuerspannung verringert sich die Auslenkung des auslenkbaren Endes 33' des Biegers 22' gegenüber der Isolationsschicht 16 in den ersten fünf Inkrementen zunehmend, um im darauffolgenden Inkrement der Ansteuerspannung schlagartig eine Auslenkung von 0 zu zeigen, was einem Eintritt des Pull-In-Effekts entspricht. Eine Auflösung des Stellweges zwischen dem fünften und sechsten Inkrement ist, unter Berücksichtigung der Schrittweite der Ansteuerspannung, nicht möglich. Die maximale Ansteuerspannung für eine analoge Auslenkung des Aktuators mit der Variante A der stationären Elektrode 14 ist dementsprechend auf einen Spannungsbereich von 0 bis zum Eintritt des Pull-In-Effekts begrenzt.

Die weiteren Graphen 74b, 74 c und 74d liegen im ersten Abschnitt der Abszisse übereinander, da in diesem Bereich lediglich die jeweilig identisch ausgeformten Segmente 14b', 14c' und 14d' mit einer Spannung gegenüber Biegerelektrode 26 oder Auslegerelektrode 29 beaufschlagt werden, wohingegen die Segmente 14b", 14c" und 14d", welche geometrisch unterschiedlich ausgebildet sind, noch mit keiner Spannung beaufschlagt werden. Erkennbar ist, dass eine, dem fünften Inkrement der Ansteuerspannung des Segments 14a' vergleichbare Auslenkung des auslenkbaren Endes 33' erst im sechsten Inkrement der Ansteuerspannung erreicht wird. Die Aktuatorauslenkung für diesen Stellweg ist in diesem Fall feiner auflösbar, da die anziehende Kraft zwischen Bieger 22' und stationärer Elektrode 14 für die Varianten B-D lediglich im Bereich des Segments 14b', 14c' bzw. 14d' erzeugt wird. Wird die Spannung um ein Inkrement weiter erhöht, so zeigt sich ein starker Abfall der Aktuatorauslenkung, ähnlich zum Graphen 74a, wobei die Aktuatorauslenkung bei einer Auslenkung, die in etwa der Hälfte der ursprünglichen Auslenkung entspricht, auch bei weiter erhöhter Spannung verharrt und der Eintritt des Pull-In-Effekts über den gesamten Stellweg verhindert ist. Eine weitere Erhöhung der angelegten Spannung an den Segmenten 14b'-d' führt zu keiner erkennbaren Veränderung der Aktuatorauslenkung. Im weiteren Verlauf der Abszisse wird die Spannung an den Segmenten 14b'-d' konstant gehalten und die Spannung an den zweiten Segmenten 14b"-d" schrittweise erhöht.

Erkennbar ist, dass in Graph 74b, die Auslenkung des Aktuators zeigend, welcher die stationäre Elektrode 14 in Variante B umfasst, die Aktuatorauslenkung bei einer erhöhten Spannung am Segment 14b" im zweiten Inkrement auf ca. ein Drittel der ursprünglichen Auslenkung reduziert ist, um im nächsten Inkrement der Ansteuerspannung am Segment 14b" den Eintritt des Pull-In-Effekts zu zeigen. Demgegenüber zeigt Graph 74c einen kontinuierlicheren Verlauf der Aktuatorauslenkung in Richtung 0. Durch die dreieckige Geometrie des Segments 14c' reduziert sich mit einer sich verjüngenden lateralen Ausdehnung des Segments 14c' die zwischen der stationären Elektrode 14 und der gegenüberliegenden Elektrode lokal induzierte anziehende Kraft, so dass bei identischer elektrischer Spannung die elektrostatische Kraft zwischen der stationären Elektrode 14 und der Auslegerelektrode 29 bzw. Biegerelektrode 26 lokal variiert.

Graph 74c weist für das fünfte Inkrement der Ansteuerspannung an dem Segment 14c" eine geringe Aktuatorauslenkung nahe, jedoch größer 0 auf, was eine Abwesenheit des PulL-In-Effekts zeigt. Erst im weiteren Verlauf der Ansteuerspannung des Segments 14c" wird der Stellweg des Aktuators auf 0 verkleinert, jedoch erfolgt dies in kleinen Schritten und damit entgegen dem plötzlichen Auftreten des Pull-In-Effekts.

Durch die nichtlineare Verjüngung des Segments 14d" zeigt Graph 74d einen über den gesamten Spannungsbereich vollständig auflösbaren Stellweg, wobei eine größere elektrische Spannung bis zur Reduktion des Stellweges auf 0 anlegbar ist, womit der verfügbare Stellweg feiner auflösbar ist. Ursächlich hierfür ist die gegenüber dem Segment 14c" nichtlinear verjüngte laterale Ausdehnung des Segments 14d".

Je nach erforderlicher Kennlinie des elektrostatischen Aktuators kann aufgrund der Geometrien der ersten Segmente 14a'-d' und/oder der zweiten Segmente 14b"-d" und möglicher zusätzlicher Elektrodensegmente, eine beliebige Kennlinie des Stellwegs des elektrostatischen Aktuators definiert werden.

Alternativ oder zusätzlich ist denkbar, dass anstelle oder neben einer Unterteilung der stationären Elektrode in Segmente die Ausleger- und/oder Biegerelektrode in zwei oder mehr Segmente unterteilt ist, um eine Anpassung des Stellweges des Aktuators in Abhängigkeit von angelegter elektrischer Spannung zu definieren.

Eine Veränderung der lateralen Ausdehnung der Elektroden ermöglicht eine auch von der Geometrie der Elektroden abhängige Anpassung der zwischen zwei Elektroden erzeugten Kraft und mithin der resultierenden Auslenkung des elektrostatischen Aktuators. Insbesondere können durch die Geometrie, zusätzlich zur Reduktion des Spaltes zwischen Ausleger und stationärer Elektrode, Nichtlinearitäten der elektrostatischen Krafterzeugung berücksichtigt bzw. ausgeglichen werden.

Alternativ oder zusätzlich können die mechanischen Vorspannungen und die daraus resultierenden vorgekrümmten Biegerstrukturen genutzt werden, um über einen Hebel die vom Aktuator erzeugte Auslenkung in eine größere Auslenkung zu übersetzen.

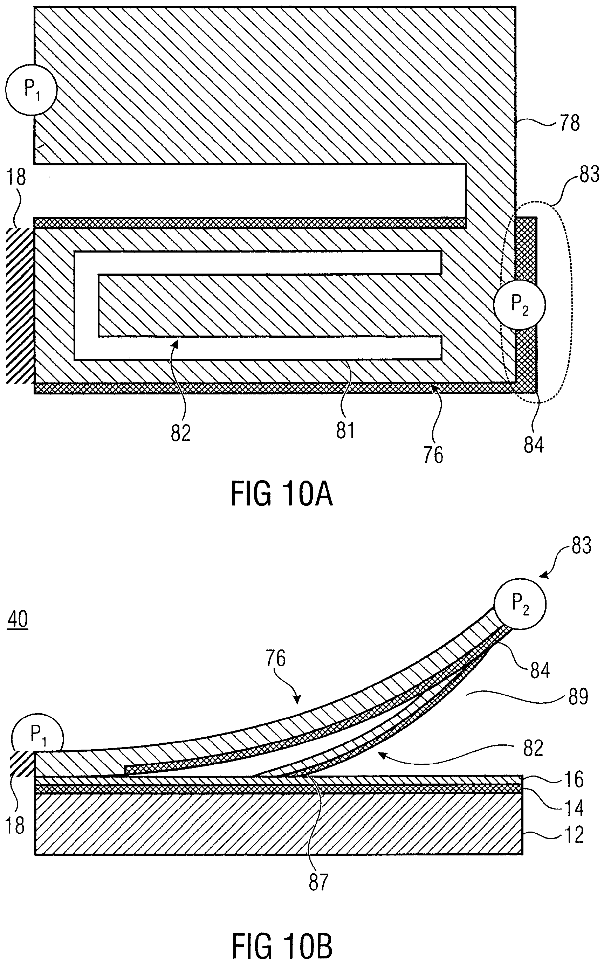

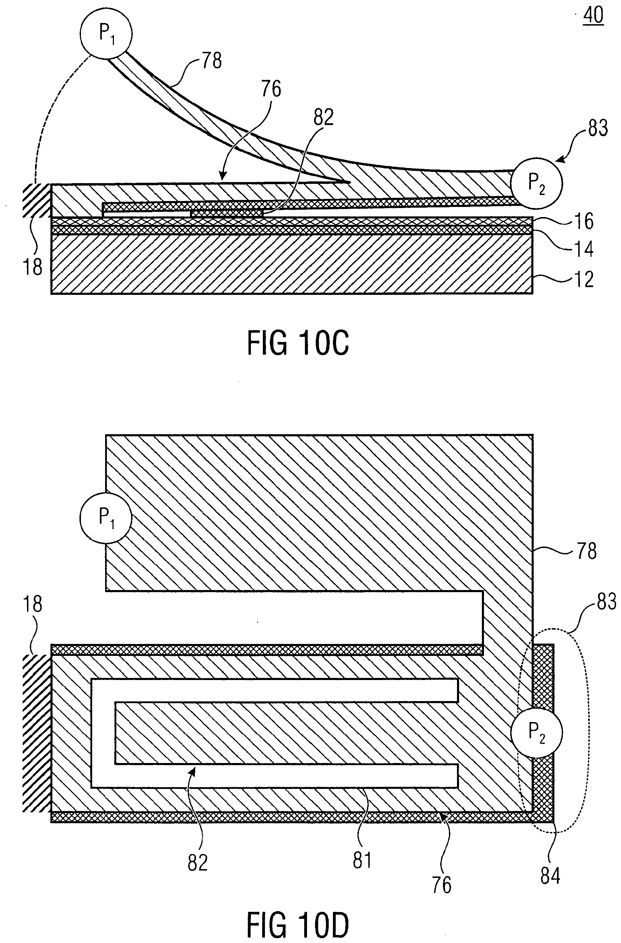

Fig. 10 zeigt eine Vorrichtung 40, bei der an einem Bieger 76 ein Balkenelement 78 mit einer ähnlichen Ausdehnung wie der Bieger 76 versetzt an einem auslenkbaren Ende 83 des Biegers 76 angeordnet ist.

Fig. 10a zeigt eine Aufsicht auf Vorrichtung 40 in einem elektrisch spannungsfreien, unausgelenkten Zustand. An einer der stationären Elektrode 14 zugewandten Seite des Biegers 76 sowie eines durch eine Aussparung 81 definierten Auslegers 82, ist eine Elektrode 84 angeordnet. Das der festen Einspannung 18 abgewandte auslenkbare Ende 83 des Biegers 76 definiert den Punkt $P_2$. Das Balkenelement 78 umfasst eine Krümmung, so dass in einer Seitenansicht der Vorrichtung das Balkenelement 78 in etwa deckungsgleich mit dem Bieger 76 angeordnet ist, wie es in Fig. 10b gezeigt ist, wobei das auslenkbare Ende 83 des Biegers 76 mit einem eingespannten Ende des Balkenelementes 78 verbunden ist.

Fig. 10b zeigt Vorrichtung 40 aus Fig. 10a in einer Seitenansicht. An einem Ausleger 82 ist ein Abschnitt der Elektrode 84 angeordnet, so dass eine Auslegerelektrode und eine Biegerelektrode einstückig sind und ein identisches elektrisches Potential umfassen. Der Ausleger 82 schließt an einer Kontaktstelle 87 einen Spalt 89 zwischen der stationären Elektrode 14 und der Auslegerelektrode partiell. Ein auslenkbares Ende des Balkenelements 78 ist mit dem Punkt $P_1$ bezeichnet und dem eingespannten Ende des Balkenelements gegenüberliegend angeordnet.

Fig. 10c zeigt eine Seitenansicht analog Fig. 10b der Vorrichtung 40 in einem ausgelenkten Zustand. Die Auslenkung des Biegers 76 führt gegenüber Fig. 10a zu einem verringerten Abstand zwischen dem Punkt $P_2$ und der stationären Elektrode 14, wie es in vorangegangenen Ausführungsbeispielen beschrieben wurde. Gleichzeitig ist der Bieger 76 mit dem Balkenelement 78 bezüglich der Seitenansicht nicht mehr deckungsgleich, so dass die Krümmung des Balkenelements 78 dazu führt, dass der Punkt $P_1$ einen größeren Abstand zur Ebene der stationären Elektrode 14 umfasst, als im unausgelenkten Zustand.

Fig. 10d zeigt eine Aufsicht der Vorrichtung 40 im ausgelenkten Zustand analog Fig. 10c. Die laterale Ausdehnung des Balkenelements 78 ist gegenüber der Fig. 10a und bezogen auf die Aufsicht verkleinert.

Durch die Anordnung des Balkenelements 78 wird der Stellweg des Aktuators durch das Hebelgesetz derart umgelenkt, dass zum einen anstelle der Verkleinerung eines Abstands zwischen Biegerelektrode und statischer Elektrode bei zunehmender Ansteuerspannung ein mit zunehmender Ansteuerspannung zunehmender Stellweg zwischen dem Punkt $P_1$ des Balkenelements 78 und der Ebene der stationären Elektrode 14 nutzbar ist. Gleichzeitig kann über die voneinander unabhängige Definition der axialen Ausdehnungen des Biegers 76 und des Balkenelements 78 gemäß dem Hebelgesetz eine Kraft-Weg-Übersetzung definiert werden, die eine Vergrößerung des erzielbaren Stellweges und/oder eine Vergrößerung einer Stellkraft ermöglicht.

Der Hub des elektrostatischen Aktuators kann durch die Hebelübersetzung vergrößert werden. Am Punkt $P_1$ können Funktionselemente vorgesehen werden, beispielsweise Festkörperfedern, welche Polymerlinsen oder Mikrospiegel halten. Das Auslenkungsverhalten des Biegers kann gemäß vorangegangenen Ausführungsbeispielen durch Formanpassung der Elektroden nach Bedarf angepasst werden.

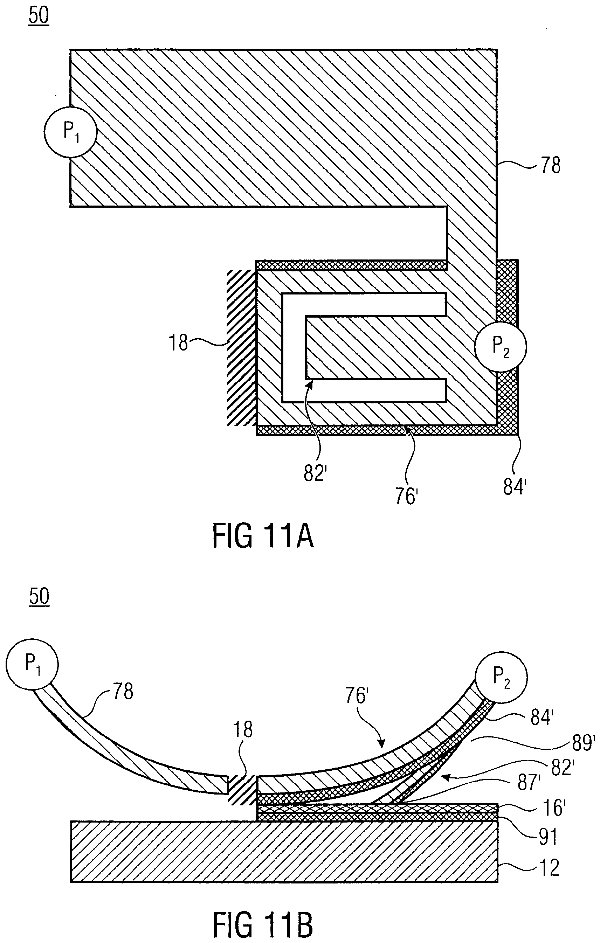

Fig. 11a zeigt eine Aufsicht auf eine Vorrichtung 50 mit einem 76' Bieger und einem Balkenelement 78' analog Vorrichtung 40, bei der die axiale Ausdehnung des Biegers 76' gegenüber der axialen Ausdehnung des Balkenelements 78' verkürzt ist.

Fig. 11b zeigt eine Seitenansicht der Vorrichtung 50 in einem unausgelenkten Zustand, bei der analog zur Vorrichtung 40 entlang des Verlaufs des Biegers 76' hin zum Punkt $P_2$ der Bieger 76' und das Balkenelement 78 deckungsgleich verlaufen. Ein Ausleger 82' schließt an einer Kontaktstelle 87' einen Spalt 89' zwischen einer Elektrode 84' und einer stationären Elektrode 91 partiell. Das Balkenelement 78 verläuft vom Punkt $P_2$ ausgehend in Richtung der festen Einspannung 18 parallel zum Bieger 76' in der Betrachtungsebene, ist jedoch im Gegensatz zur Vorrichtung 40 dahin gehend angeordnet, dass sein Verlauf über die feste Einspannung 18 hinaus verläuft, so dass es eine größere axiale Ausdehnung umfasst als der Bieger 76'.

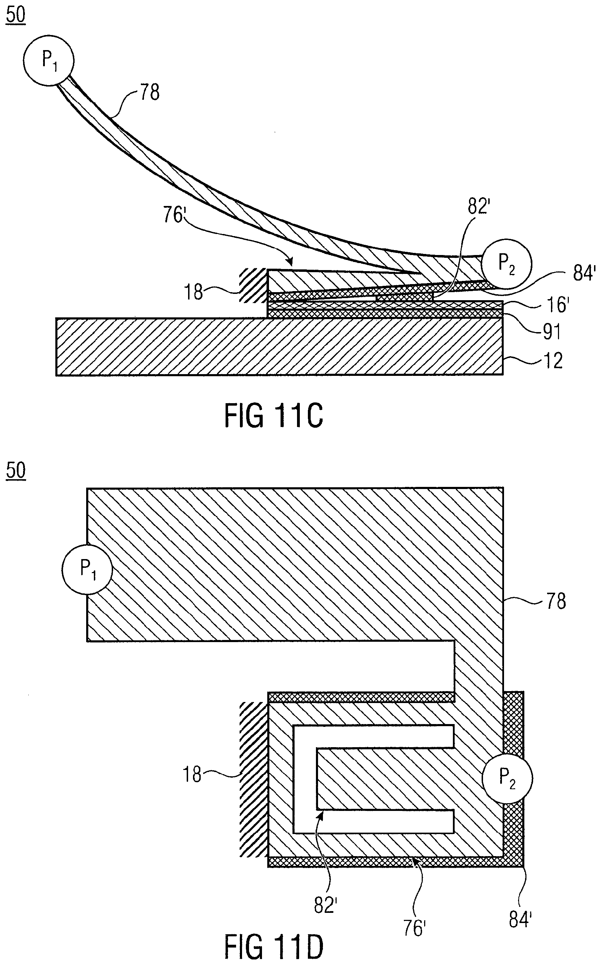

Fig. 11c zeigt eine Seitenansicht der Vorrichtung 50 in einem ausgelenkten Zustand. Analog Fig. 10c ist der Punkt $P_2$ benachbart zur stationären Elektrode 91 bewegt, was zu einer Vergrößerung des Abstands des Punkts $P_1$ zum Substrat 12 führt. Aufgrund der größeren axialen Ausdehnung des Balkenelements 78 gegenüber der axialen Ausdehnung des Biegers 76' bei identischen Krümmungen ist die Zunahme des Abstands des Punkts $P_1$ zum Substrat 12 größer als die Abnahme des Abstands des Punkts $P_2$ zur stationären Elektrode 91.

Fig. 11d zeigt den ausgelenkten Zustand der Vorrichtung 50 in einer Aufsicht, wobei aufgrund der Auslenkung analog Fig. 10d eine verkürzte axiale Ausdehnung des Balkenelements 78 bezogen auf die Betrachtungsebene gezeigt ist.

Gemäß den vorangegangenen Erläuterungen kann durch die Definition eines Verhältnisses der axialen Ausdehnung des Biegers beziehungsweise des Balkenelements eine Hebelübersetzung der Aktuatorkraft und/oder des Aktuatorstellweges definiert werden.

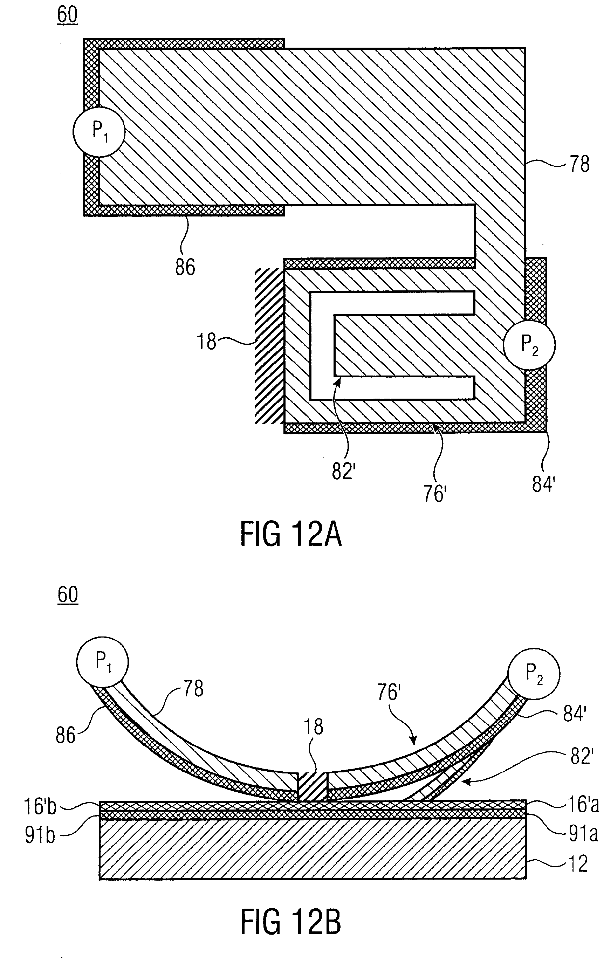

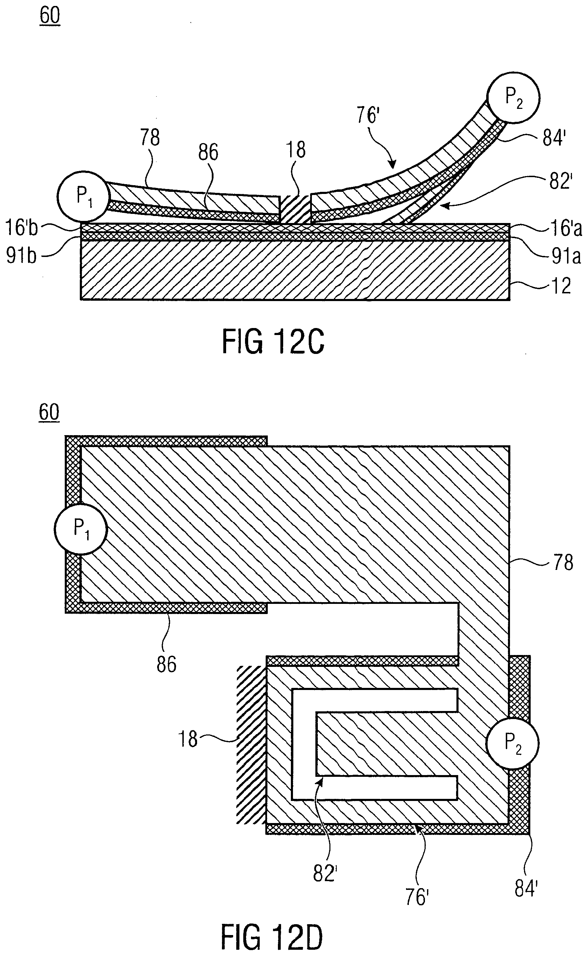

Fig. 12 zeigt eine Vorrichtung 60, die Vorrichtung 50 aus Fig. 11 dahingehend erweitert, dass bei der an einem vom auslenkbaren Ende des Balkenelements 78 ausgehenden Abschnitts des Balkenelements 78 eine Balkenelektrode 86 angeordnet ist.

Fig. 12a zeigt eine Aufsicht auf die Vorrichtung 60. Von dem auslenkbaren Ende des Balkenelements 78 ausgehend ist die Balkenelektrode 86 mit einer axialen Ausdehnung von einem auslenkbaren Ende bis in etwa in den Bereich der festen Einspannung 18 angeordnet.

Fig. 12b zeigt eine Seitenansicht der Vorrichtung 60 analog der Seitenansicht aus Fig. 11b, bei der an dem Substrat 12 der Balkenelektrode 86 gegenüberliegend eine stationäre Elektrode 91b angeordnet ist, die von einer Isolationsschicht 16'b bedeckt ist, wobei die Isolationsschicht 16'b einen elektrischen Kontakt der Balkenelektrode 86 mit der stationären Elektrode 91b verhindert. Die stationäre Elektrode 91a entspricht der stationären Elektrode 91 aus Fig. 11 und ist der Elektrode 84' gegenüberliegend angeordnet und von der Isolationsschicht 16'a, welche der Isolationsschicht 16' aus Fig. 11 entspricht, bedeckt.

Durch den parallelen Verlauf der Krümmungen des Biegers 76' und des Balkenelements 78 ist der Abstand zwischen Balkenelektrode 86 und der stationären Elektrode 91b im Bereich entlang der lateralen Verlängerung der festen Einspannung 18 minimal.

Fig. 12c zeigt eine Seitenansicht der Vorrichtung 60, bei der zwischen der Balkenelektrode 86 und der stationären Elektrode 91b eine elektrische Spannung angelegt ist. Die dadurch entstehende Anziehungskraft zwischen der Balkenelektrode 86 und der stationären Elektrode 91b führt dazu, dass das auslenkbare Ende des Balkenelements in Richtung der stationären Elektrode 91b ausgelenkt wird und sich der Abstand zwischen dem Punkt $P_1$ und der stationären Elektrode 91b verringert.

Fig. 12d zeigt eine Aufsicht der Vorrichtung 60 im Zustand der Fig. 12c, bei dem zwischen der Balkenelektrode 86 und der stationären Elektrode 91b eine elektrische Spannung angelegt ist. Die axiale Ausdehnung des Balkenelements 78 ist in der Ebene der Aufsicht durch die in Fig. 12c beschriebene Auslenkung vergrößert.

Durch die Anordnung einer Balkenelektrode kann die Auslenkung des Punkts $P_1$ unabhängig von der Auslenkung des Punkts $P_2$ justiert werden, insbesondere kann sowohl eine Verringerung des Abstands zwischen dem Punkt $P_1$ und der gegenüberliegenden stationären Elektrode 91b justiert werden, ohne dass eine elektrische Spannung an der Elektrode 84' angelegt wird, als auch eine Nachjustierung eines gemäß Fig. 11c ausgelenkten Balkenelements erfolgen, indem nach erfolgter Auslenkung des Balkenelements eine Verringerung des Abstands $P_1$ zur gegenüberliegend angeordneten stationären Elektrode 91b durch Anlegen einer elektrischen Spannung zwischen den Elektroden 86 und 91b eingestellt wird.

Alternativ oder zusätzlich kann Vorrichtung 60 derart genutzt werden, dass von einem unausgelenkten Zustand ausgehend in einem ersten Schritt der Aktuator analog Vorrichtung 50 in Fig. 11c ausgelenkt wird und in einem zweiten Schritt ein Anlegen einer elektrischen Spannung zwischen der Balkenelektrode 86 und der stationären Elektrode 91b zu einer Positionierung des Punktes $P_1$ führt. In diesem Fall ist die Bewegungsrichtung des Punktes $P_1$ analog zu einem auslenkbaren Ende 33, 33' oder 83 der vorangegangenen Ausführungsbeispiele, wobei eine Erhöhung der Ansteuerspannung eine anziehende Kraft und mithin eine Verringerung des Stellweges bewirkt. Durch das Balkenelement 78 ist der nutzbare Stellweg des Aktuators gegenüber Ausführungsbeispielen ohne Balkenelement vergrößert. Zudem ist der Punkt $P_1$ in eine der stationären Elektrode 91b zugewandte Richtung und in eine entgegengesetzte Richtung beweglich.

In alternativen Ausführungsbeispielen sind die stationären Elektroden 91a und 91b einstückig ausgeformt. Dies bietet insbesondere während eines Herstellungsverfahrens Vorteile, wenn die stationäre Elektrode im späteren Betrieb das Referenzpotenzial des elektrostatischen Antriebs, bspw. das Massepotential, umfasst und somit sowohl als Referenzpunkt gegenüber der an Biegern angeordneten Elektroden als auch gegenüber Balkenelektroden als Referenzpotenzial dient.

In weiteren Ausführungsbeispielen ist die Isolationsschicht 16'a einstückig mit der Isolationsschicht 16'b gebildet.

Obwohl in vorangegangenen Ausführungsbeispielen die Elektroden stets an Biegern, Auslegern oder Balkenelementen angeordnet waren, ist es gemäß alternativen Ausführungsbeispielen ebenfalls möglich, dass die Elektroden in das Material der Bieger, Ausleger oder Balkenelemente eingebettet sind, insbesondere wenn Bieger, Ausleger oder Balkenelemente aus polymeren Werkstoffen gebildet sind. Gemäß diesen Ausführungsbeispielen wird eine Isolationsschicht zwischen zwei gegenüberliegend angeordneten Elektroden aus dem Material der Bieger, Ausleger oder Balkenelemente gebildet, so dass die Anordnung einer weiteren Isolationsschicht entfällt.

Obwohl in vorangegangenen Ausführungsbeispielen elektrostatische Aktuatoren stets derart beschrieben wurden, dass ein Anlegen einer elektrischen Spannung und mithin eines elektrischen Feldes zwischen zwei Elektroden zu anziehenden Kräften zwischen den Elektroden und mithin zu einer Verringerung des Abstandes zwischen den Elektroden führt, versteht es sich, dass eine elektrische Spannung auch derart zwischen den Elektroden angelegt werden kann, dass daraus abstoßende Kräfte zwischen den Elektroden und mithin eine Vergrößerung des Abstandes zwischen den Elektroden resultieren.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

**1.** Elektrostatischer Aktuator, mit:

einer stationären Elektrode (14; 14a-b; 91; 91a-b);
einem einseitig fest eingespannten Bieger (22; 22'; 56; 76; 76'),
wobei der Bieger (22; 22'; 56; 76; 76') einen Ausleger (28; 28a-b; 28'; 28'a-b; 58; 58'; 58"; 58"'; 60; 60'; 66a-d; 82; 82') mit einer Auslegerelektrode (29; 29a-b) umfasst, die der stationären Elektrode (14; 14a-b; 91; 91a-b) in einem Überlappungsbereich gegenüberliegend angeordnet ist; und
wobei der Ausleger (28; 28a-b; 28'; 28'a-b; 58; 58'; 58"; 58"'; 60; 60'; 66a-d; 82; 82') in einem Ruhezustand ein erstes, in der Ebene des Biegers angeordnetes Ende aufweist, **dadurch gekennzeichnet dass** der Ausleger ein zweites aus einer Ebene, in der der Bieger (22; 22'; 56; 76; 76') angeordnet ist, in Richtung der stationären Elektrode (14; 14a-b; 91; 91a-b) ausgelenktes Ende aufweist, um bei Anlegen eines elektrischen Feldes eine Verformung der Auslegerelektrode (29; 29a-b) oder des Biegers (22; 22'; 56; 76; 76') zu bewirken.

**2.** Vorrichtung nach Anspruch 1, bei der ein isolierender Abstandshalter (16; 16'; 16'a-b) zwischen der Auslegerelektrode (29; 29a-b) und der stationären Elektrode (14; 14a-b; 91; 91a-b) angeordnet ist.

**3.** Vorrichtung nach Anspruch 1 oder 2, bei der der isolierende Abstandshalter (16; 16'; 16'a-b) zumindest teilweise auf der Auslegerelektrode (29) oder der stationären Elektrode (14; 14a-b; 91; 91a-b) angeordnet ist.

**4.** Vorrichtung nach einem der vorangegangenen Ansprüche, bei der die stationäre Elektrode (14; 14a-b; 91; 91a-b) einen Abschnitt (31; 31'; 31'a-b; 87; 87') umfasst, auf dem die Auslegerelektrode (29; 29a-b) aufliegt.

**5.** Vorrichtung nach einem der Ansprüche 1 bis 3, bei der ein zwischen der Auslegerelektrode (29; 29a-b) und der stationären Elektrode (14; 14a-b; 91; 91a-b) angeordneter Spalt (17) in einem Bereich der Auslegerelektrode (29; 29a-b) partiell verkleinert ist.

**6.** Vorrichtung nach einem der vorangegangenen Ansprüche, bei der die Geometrie der Auslegerelektrode (29; 29a-b) oder der stationären Elektrode (14; 14a-b; 91; 91a-b) ausgebildet ist, um ein linearisiertes Verhältnis von zwischen den Elektroden (14; 14a-b; 91; 91a-b; 29; 29a-b) angelegter Spannung und der resultierenden Verformung des Biegers (22;

22'; 56; 76; 76') oder der Auslegerelektrode (29; 29ab) aufzuweisen.

**7.** Vorrichtung nach einem der vorangegangenen Ansprüche, mit einer Federstruktur (62), die an einem der festen Einspannung (18) gegenüberliegend angeordneten, auslenkbaren Ende (33; 33'; 33'a-b; 61; 61'; 83) des Biegers (22; 22'; 56; 76; 76') angeordnet ist.

**8.** Vorrichtung nach einem der vorangegangenen Ansprüche, bei der ein Bieger mehrere Auslegerelektroden (29; 29a-b) umfasst.

**9.** Vorrichtung nach einem der vorangegangenen Ansprüche, bei der die stationäre Elektrode (14; 14a-b; 91; 91a-b) zumindest zwei Teilelektroden (14a'; 14b'; 14b"; 14c'; 14c"; 14d'; 14d") umfasst.

**10.** Vorrichtung nach einem der vorangegangenen Ansprüche, bei der die Auslegerelektrode (29; 29a-b) zumindest zwei Teilelektroden umfasst.

**11.** Vorrichtung nach Anspruch 9 oder 10, bei der eine oder mehrere der Teilelektroden eine veränderliche laterale Ausdehnung umfassen.

**12.** Vorrichtung nach einem der vorangegangenen Ansprüche, bei der am auslenkbaren Ende (33; 33'; 33'a-b; 61; 61'; 83) des Biegers (22; 22'; 56; 76; 76') ein Balkenelement (78) angeordnet ist, welches in einem Abschnitt lateral benachbart und entlang des Biegers (22; 22'; 56; 76; 76') verläuft.

**13.** Vorrichtung nach Anspruch 12, bei der das Balkenelement (78) eine Krümmung entlang eines axialen Verlaufs umfasst.

**14.** Vorrichtung nach Anspruch 12 oder 13, bei der das Balkenelement (78) eine Hebelelektrode (86) umfasst.

**15.** Vorrichtung, mit:

einem ersten elektrostatischen Aktuator nach einem der Ansprüche 1-14;
einem zweiten elektrostatischen Aktuator nach einem der Ansprüche 1-14,
wobei der erste und der zweite elektrostatische Aktuator derart angeordnet sind, dass die auslenkbaren Enden (33; 33'; 33'a-b; 61; 61'; 83) der Bieger (22; 22'; 56; 76; 76') gegenüberliegend sind; und
einer Federstruktur (62), die zwischen den auslenkbaren Enden (33; 33'; 33'a-b; 61; 61'; 83) der Bieger (22; 22'; 56; 76; 76') angeordnet ist und die auslenkbaren Enden (33; 33'; 33'a-b; 61; 61'; 83) verbindet.

**16.** Vorrichtung nach Anspruch 15, bei der an der Federstruktur ein Funktionselement angeordnet ist.

**17.** Verfahren zum Herstellen eines elektrostatischen Aktuators, umfassend:

Anordnen einer stationären Elektrode (14; 14a-b; 91; 91a-b);
Anordnen eines einseitig fest eingespannten Biegers (22; 22'; 56; 76; 76'),
wobei der Bieger (22; 22'; 56; 76; 76') einen Ausleger (28; 28a-b; 28'; 28'a-b; 58; 58'; 58"; 58"'; 60; 60'; 66a-d; 82; 82') mit einer Auslegerelektrode (29; 29a-b) umfasst, die der stationären Elektrode (14; 14a-b; 91; 91a-b) in einem Überlappungsbereich gegenüberliegend angeordnet ist; und
wobei der Ausleger (28; 28a-b; 28'; 28'a-b; 58; 58'; 58"; 58"'; 60; 60'; 66a-d; 82; 82') in einem Ruhezustand ein erstes, in der Ebene des Biegers angeordnetes Ende und ein zweites aus einer Ebene, in der der Bieger (22; 22'; 56; 76; 76') angeordnet ist, in Richtung der stationären Elektrode (14; 14a-b; 91; 91a-b) ausgelenktes Ende aufweist, um bei Anlegen eines elektrischen Feldes eine Verformung der Auslegerelektrode (29; 29a-b) oder des Biegers (22; 22'; 56; 76; 76') zu bewirken.

## Claims

**1.** Electrostatic actuator, comprising:

a stationary electrode (14; 14a-b; 91; 91a-b);
a fixedly cantilevered bender (22; 22'; 56; 76; 76'),
wherein the bender (22; 22'; 56; 76; 76') includes a cantilever (28; 28a-b; 28'; 28'a-b; 58; 58'; 58"; 58"'; 60; 60'; 66a-d; 82; 82') with a cantilever electrode (29; 29a-b) disposed opposite to the stationary electrode (14; 14a-b; 91; 91a-b) in an overlapping area;
wherein the cantilever (28; 28a-b; 28'; 28'a-b; 58; 58'; 58"; 58"'; 60; 60'; 66a-d; 82; 82') comprises, in an idle state, a first end disposed in the plane of the bender, **characterized in that** the bender comprises a second end deflected out of a plane where the bender (22; 22'; 56; 76; 76') is disposed in the direction of the stationary electrode (14; 14a-b; 91; 91a-b), to effect, when applying an electric field, a deformation of the cantilever electrode (29; 29a-b) or the bender (22; 22'; 56; 76; 76').

**2.** Apparatus according to claim 1, wherein an insulating spacer (16; 16'; 16'a-b) is disposed between the cantilever electrode (29; 29a-b) and the stationary electrode (14; 14a-b; 91; 91a-b).

**3.** Apparatus according to claim 1 or 2, wherein the insulating spacer (16; 16'; 16'a-b) is disposed at least partly on the cantilever electrode (29) or the stationary electrode (14; 14a-b; 91; 91a-b).

**4.** Apparatus according to any of the previous claims, wherein the stationary electrode (14; 14a-b; 91; 91a-b) includes a portion (31; 31'; 31'a-b; 87; 87') on which the cantilever electrode (29; 29a-b) is supported.

**5.** Apparatus according to any of claims 1 to 3, wherein a gap (17) disposed between the cantilever electrode (29; 29a-b) and the stationary electrode (14; 14a-b; 91; 91 a-b) is partially reduced in an area of the cantilever electrode (29; 29a-b).

**6.** Apparatus according to any of the previous claims, wherein the geometry of the cantilever electrode (29; 29a-b) or the stationary electrode (14; 14a-b; 91; 91a-b) is implemented to comprise a linearized ratio of voltage applied between the electrodes (14; 14a-b; 91; 91a-b; 29; 29a-b) and the resulting deformation of the bender (22; 22'; 56; 76; 76') or the cantilever electrode (29; 29a-b).

**7.** Apparatus according to any of the previous claims comprising a spring structure (62) disposed on the deflectable end (33; 33'; 33'a-b; 61; 61'; 83) of the bender (22; 22'; 56; 76; 76') disposed opposite to the fixed clamping (18).

**8.** Apparatus according to any of the previous claims, wherein the bender includes several cantilever electrodes (29; 29a-b).

**9.** Apparatus according to any of the previous claims, wherein the stationary electrode (14; 14a-b; 91; 91a-b) includes at least two partial electrodes (14a'; 14b'b; 14b"; 14c'; 14c"; 14d'; 14d").

**10.** Apparatus according to any of the previous claims, wherein the cantilever electrode (29; 29a-b) includes at least two partial electrodes.

**11.** Apparatus according to claim 9 or 10, wherein one or several of the partial electrodes include a variable lateral expansion.

**12.** Apparatus according to any of the previous claims, wherein a beam element (78) is disposed on the deflectable end (33; 33'; 33'a-b; 61; 61'; 83) of the bender (22; 22'; 56; 76; 76'), which runs in one portion laterally adjacent to and along the bender (22; 22'; 56; 76; 76').

**13.** Apparatus according to claim 12, wherein the beam element (78) includes a curvature along an axial curve.

**14.** Apparatus according to claim 12 or 13, wherein the beam element (78) includes a lever electrode (86).

**15.** Apparatus, comprising:

a first electrostatic actuator according to any of claims 1 to 14;
a second electrostatic actuator according to any of claims 1 to 14,
wherein the first and the second electrostatic actuators are disposed such that the deflectable ends (33; 33'; 33'a-b; 61; 61'; 83) of the benders (22; 22'; 56; 76; 76') are opposite; and
a spring structure (62) disposed between the deflectable ends (33; 33'; 33'a-b; 61; 61'; 83) of the benders (22; 22'; 56; 76; 76') and connecting the deflectable ends (33; 33'; 33'a-b; 61; 61'; 83).

**16.** Apparatus according to claim 15, wherein a functional element is disposed on the spring structure.

**17.** Method for producing an electrostatic actuator, comprising:

disposing a stationary electrode (14; 14a-b; 91; 91 a-b);
disposing a fixedly cantilevered bender (22; 22'; 56; 76; 76');
wherein the bender (22; 22'; 56; 76; 76') includes a cantilever (28; 28a-b; 28'; 28'a-b; 58; 58'; 58"; 58'"; 60; 60'; 66a-d; 82; 82') with a cantilever electrode (29; 29a-b), which is disposed opposite to the stationary electrode (14; 14a-b; 91; 91a-b) in an overlapping area;
wherein the cantilever (28; 28a-b; 28'; 28'a-b; 58; 58'; 58"; 58'"; 60; 60'; 66a-d; 82; 82') comprises, in an idle state, a first end disposed in the plane of the bender and a second end deflected out of a plane where the bender (22; 22'; 56; 76; 76') is disposed in the direction of the stationary electrode (14; 14a-b; 91; 91a-b), to effect, when applying an electric field, a deformation of the cantilever electrode (29; 29a-b) or the bender (22; 22'; 56; 76; 76').

## Revendications

**1.** Actionneur électrostatique, avec:

une électrode stationnaire (14; 14a-b; 91; 91a-b);
une cintreuse (22; 22'; 56; 76; 76') serrée fermement d'un côté,

dans lequel la cintreuse (22; 22'; 56; 76; 76') comporte une console (28; 28a-b; 28'; 28'a-b; 58; 58'; 58"; 58"'; 60; 60'; 66a-d; 82; 82') avec une électrode de console (29; 29a-b) qui est disposée opposée à l'électrode stationnaire (14; 14a-b; 91; 91a-b) dans une zone de recouvrement; et

dans lequel la console (28; 28a-b; 28'; 28'a-b; 58; 58'; 58"; 58"'; 60; 60'; 66a-d; 82; 82') présente, dans un état de repos, une première extrémité disposée dans le plan de la cintreuse, **caractérisé par le fait que** la console présente une deuxième extrémité déviée du plan dans lequel est disposée la cintreuse (22; 22'; 56; 76; 76'), en direction de l'électrode stationnaire (14; 14a-b; 91; 91a-b) pour provoquer, lors de l'application d'un champ électrique, une déformation de l'électrode de console (29; 29a-b) ou de la cintreuse (22; 22'; 56; 76; 76').

**2.** Dispositif selon la revendication 1, dans lequel une entretoise isolante (16; 16'; 16'a"b) est disposée entre l'électrode de console (29; 29a-b) et l'électrode stationnaire (14; 14a-b; 91; 91a-b).

**3.** Dispositif selon la revendication 1 ou 2, dans lequel l'entretoise isolante (16; 16'; 16'a-b) est disposée au moins partiellement sur l'électrode de console (29) ou l'électrode stationnaire (14; 14a-b; 91; 91a-b).

**4.** Dispositif selon l'une des revendications précédentes, dans lequel l'électrode stationnaire (14; 14a-b; 91; 91a-b) comporte un segment (31; 31'; 31'a-b; 87; 87') sur lequel repose l'électrode de console (29; 29a-b).

**5.** Dispositif selon l'une des revendications 1 à 3, dans lequel une fente (17) disposée entre l'électrode de console (29; 29a-b) et l'électrode stationnaire (14; 14a-b; 91; 91a-b) est partiellement réduite dans une zone de l'électrode de console (29; 29a-b).

**6.** Dispositif selon l'une des revendications précédentes, dans lequel la géométrie de l'électrode de console (29; 29a-b) ou de l'électrode stationnaire (14; 14a-b; 91; 91a-b) est réalisée de manière à présenter un rapport linéarisé entre la tension appliquée entre les électrodes (14; 14a-b; 91; 91a-b; 29; 29a-b) et la déformation résultante de la cintreuse (22; 22'; 56; 76; 76') ou l'électrode de console (29; 29a-b).

**7.** Dispositif selon l'une des revendications précédentes, avec une structure de ressort (62) disposée à une extrémité pouvant être déviée (33; 33'; 33'a-b; 61; 61'; 83) de la cintreuse (22; 22'; 56; 76; 76') disposée opposée au serrage fixe (18).

**8.** Dispositif selon l'une des revendications précédentes, dans lequel une cintreuse comporte plusieurs d'électrodes de console (29; 29a-b).

**9.** Dispositif selon l'une des revendications précédentes, dans lequel l'électrode stationnaire (14; 14a-b; 91; 91a-b) comporte au moins deux électrodes partielles (14a', 14b', 14b", 14c', 14c"; 14d'; 14d").

**10.** Dispositif selon l'une des revendications précédentes, dans lequel l'électrode de console (29; 29a-b) comporte au moins deux électrodes partielles.

**11.** Dispositif selon la revendication 9 ou 10, dans lequel une ou plusieurs des électrodes partielles comportent une extension latérale variable.

**12.** Dispositif selon l'une des revendications précédentes, dans lequel est disposé, à l'extrémité pouvant être déviée (33; 33'; 33'a-b; 61; 61'; 83) de la cintreuse (22; 22'; 56; 76; '76'), un élément de poutre (78) qui, dans un segment, s'étend latéralement adjacent et le long de la cintreuse (22; 22'; 56; 76; 76').

**13.** Dispositif selon la revendication 12, dans lequel l'élément de poutre (78) comporte une courbure le long d'une extension axiale.

**14.** Dispositif selon la revendication 12 ou 13, dans lequel l'élément de poutre (78) comporte une électrode de levier (86).

**15.** Dispositif, avec:

un premier actionneur électrostatique selon l'une des revendications 1 à 14;
un deuxième actionneur électrostatique selon l'une des revendications 1 à 14,
dans lequel le premier et le deuxième actionneur électrostatique sont disposés de sorte que les extrémités pouvant être déviées (33; 33'; 33'a-b; 61; 61'; 83) des cintreuses (22; 22'; 56; 76; 76') se trouvent opposées l'une à l'autre; et
une structure de ressort (62) qui est disposée entre les extrémités pouvant être déviées (33; 33'; 33'a-b; 61; 61'; 83) des cintreuses (22; 22'; 56; 76; 76') est qui relie les extrémités pouvant être déviées (33; 33'; 33'a-b; 61; 61'; 83).

**16.** Dispositif selon la revendication 15, dans lequel un élément fonctionnel est disposé sur la structure de ressort.

**17.** Procécé de fabrication d'un actionneur électrostatique, comprenant le fait de:

disposer une électrode stationnaire (14; 14a-b; 91; 91a-b);
disposer une cintreuse (22; 22'; 56; 76; 76') serrée fermement d'un côté,
dans lequel la cintreuse (22; 22'; 56; 76; 76') comporte une console (28; 28a-b; 28'; 28'a-b; 58; 58'; 5"; 58"; 60; 60'; 66a-d; 82; 82') avec une électrode de console (29; 29a-b) qui est disposée opposée à l'électrode stationnaire (14; 14a-b; 91; 91a-b) dans une zone de recouvrement; et dans lequel la console (28; 28a-b; 28'; 28'a-b; 58; 58'; 58"; 58'"; 60; 60'; 66a-d; 82; 82') présente, dans un état de repos, une première extrémité disposée dans le plan de la cintreuse et une deuxième extrémité déviée d'un plan dans lequel est disposée la cintreuse (22; 22'; 56; 76; 76'), en direction de l'électrode stationnaire (14; 14a-b; 91; 91a-b) pour provoquer, lors de l'application d'un champ électrique, une déformation de l'électrode de console (29; 29a-b) ou de la cintreuse (22; 22'; 56; 76; 76').

18
24
22
33
27
26
28
29
31
17
16
14
12

FIG 1A

10

18
24
28
22
35
33

FIG 1B

18
24
22
33
27
26
29
28
17
16
14
12

FIG 2

18
32
34
17
16
14
12

FIG 3A

18
32

FIG 3B

33'
27'
22'
18
26
29
17'
28'
16
31'
14
12

FIG 4A

18
22'
28'
35'
33'

FIG 4B

56
58
57
18
FIG 5A
56
58'
57'
18
FIG 5B
58"
18
57"
56
FIG 5C
18
57'''
58'''
56
FIG 5D

18
56
60
61

FIG 6A

18
56
60'
61'

FIG 6B

18
56
60
60'
61''

FIG 6C

20
18b
16b
14b
22'b
31'b
12b
29b
28'b
17'b
33'b
F1
FH1
FA2
64b
62
FH1
FA1
64a
33'a
F1
17'a
28'a
29a
12a
22'a
31'a
18a
16a
14a

FIG 7A

18b
22'b
28'b
$F_1$
33'b
62
33'a
$F_1$
28'a
22'a
18a

FIG 7B

30
72
18
66a
66b
68
66d
66c

FIG 8

33'
26
22'
29
28'
18
16
14
12
FIG 9A
14d'
1.
2.
14d"
14
D
14c'
1.
2.
14c"
14
C
14b'
1.
2.
14b"
14
B
14a'
14
A
FIG 9B

A
B
C
D
74a
74b
74c
74d
0
0
0

FIG 9C

P1
78
18
83
P2
82
81
76
84


FIG 10A

83
P2
40
76
84
89
P1
82
16
14
18
12
87


FIG 10B

40
$P_1$
78
76
82
83
$P_2$
16
14
18
12

FIG 10C

$P_1$
78
18
83
$P_2$
82
81
76
84

FIG 10D

50
P1
78
18
P2
82'
76'
84'

FIG 11A

50
P1
78
76'
18
P2
84'
89'
82'
87'
16'
91
12

FIG 11B

50
P1
78
76'
82'
P2
84'
18
16'
91
12

FIG 11C

50
P1
78
18
P2
82'
76'
84'

FIG 11D

60
P1
78
86
18
P2
82'
76'
84'

FIG 12A

60
P1
78
76'
P2
86
18
84'
82'
16'b
16'a
91b
91a
12

FIG 12B

60
P1
P2
78
86
18
76'
84'
82'
16'b
16'a
91b
91a
12

FIG 12C

60
P1
P2
78
86
18
82'
76'
84'

FIG 12D

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 20100181866 A1